# EUROPEAN PATENT SPECIFICATION

(11) **EP 3 891 517 B1**
(45) Date of publication and mention of the grant of the patent: **21.10.2026**
(21) Application number: 19882573.9
(22) Date of filing: 07.11.2019
(51) Int. Cl.: G01R 29/02, G01R 19/04, G01R 29/027, G01R 15/14, G01R 15/18, G01R 19/00

(54) **DERIVATIVE VOLTAGE AND CURRENT SENSING DEVICES**
SENSOREN ZUR MESSUNG VON ABGELEITETER SPANNUNG UND STROM
DISPOSITIFS DE DÉTECTION DE TENSION ET DE COURANT DÉRIVÉS

(30) Priority: 07.11.2018 US 201862756603 P; 06.11.2019 US 201962931344 P
(43) Date of publication of application: 13.10.2021
(73) Proprietor: Visic Technologies Ltd., 7403650 Nes Ziona (IL)
(72) Inventor: SHAPIRO, David, 7531310 Rishon Le Zion (IL); BEN-YAAKOV, Shmuel, 4580500 Tel Yitzhak (IL); BUNIN, Ilia, 5844523 Holon (IL)
(74) Representative: Prüfer & Partner mbB Patentanwälte · Rechtsanwälte
(86) International application number: PCT/IL2019/051216
(87) International publication number: WO 2020/095302

(56) References cited:
- CN-A- 108 020 793
- DE-A1- 102008 009 888
- DE-A1- 102014 014 682
- DE-A1- 102017 125 100
- DE-A1- 19 753 033
- JP-A- 2001 111 390
- JP-U- H01 153 734
- RU-C2- 2 208 903
- SU-A1- 1 575 140
- US-A- 4 251 846
- US-A1- 2002 150 140

## Description

### FIELD OF THE DISCLOSED TECHNIQUE

The disclosed technique relates to voltage and current sensing, in general, and to devices for derivative voltage and current detection and measurement in power electronics systems, in particular.

### BACKGROUND OF THE DISCLOSED TECHNIQUE

Various methods and devices for sensing voltage and current, in general, are known in the art. There is a broad range of measurement and detection techniques, some of which include: a sensing (shunt) resistor; techniques based on Faraday's law of induction such as a current transformer (CT), and the Rogowski coil method; techniques based on magnetic field sensors (e.g., Hall Effect sensors, and flux gate sensors); techniques based on the magnetoresistive effect employing magneto-resistive current sensors; techniques based on Faraday's magneto-optical effect in an optical fiber that is positioned around a current-carrying conductor; dedicated integrated circuits (IC)s; conductor trace resistance sensing in a printed circuit board (PCB); direct methods employing traditional ammeters and voltmeters, and the like. Each one of these methods has advantages and disadvantages. For example, the shunt resistor technique is relatively simple, but exhibits power losses that increase with increasing current flow through the shunt resistor. The CT technique can be used to measure high currents but may generally exhibit hysteresis, and typically an undesirable direct current (DC) component that may cause saturation of the magnetic core material of the CT (e.g., ferrite). The Rogowski coil technique exhibits low inductance and does not suffer from saturation because of an absence of a magnetic core, however, this method exhibits relatively low sensitivity and may typically necessitate the use of an amplifier, as well as an integrator circuit, which in turn requires power. Techniques based on magnetic field sensors such as the Hall Effect sensor can attain high accuracy measurements, but typically produce low-level outputs requiring signal conditioning electronics that include low-noise amplifiers and temperature compensation circuits. Magnetoresistive effect based techniques generally enable high-sensitivity measurements, but may exhibit nonlinear behavior, and may be prone to damage from external magnetic fields. Trace resistance sensing techniques are low-cost, but typically suffer from thermal drift of the conductor trace effectively altering current measurements, as well as requiring the use of an amplifier to attain useful measurements.

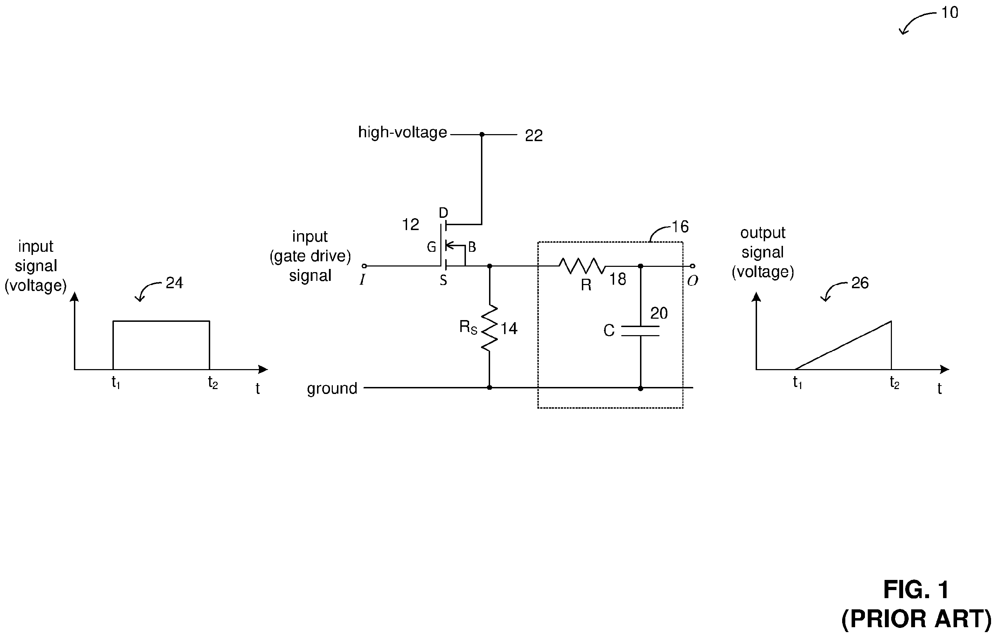

Reference is now made to Figure 1, which is a schematic illustration of a series-connected sensing circuit, generally referenced 10, for measuring current flow through a transistor-implemented switch, which is prior art. Circuit 10 includes a transistor 12, a sensing resistor 14, and a voltage sensing sub-circuit 16 (i.e., implemented via a low-pass filter/integrator circuit). Voltage sensing sub-circuit 16 includes a resistor 18 and a capacitor 20, forming a series RC circuit. Transistor 12 functions as a power switch and is typically implemented by a metal-oxide-semiconductor field-effect transistor (MOSFET), an insulated-gate bipolar transistor (IGBT), and the like. Transistor 12 typically includes the terminals denoted as gate (G), drain (D), source (S), and body (B), where the drain terminal is connected to a high-voltage power source 22, the gate terminal is connected to an input (gate drive) signal source (not shown), and the body and source terminals are interconnected to each other and further connected to sensing resistor 14, as well as to low-pass filter/integrator 16. A high-voltage is connected between the drain terminal of transistor 12 and the ground.

Figure 1 shows an input signal 24 (as a function of time) that drives the gate terminal of transistor 12. Input signal 24 is used to control the switching state of transistor 12, which in turn functions as a switch between conducting ('ON') and non-conducting ('OFF') states. For the sake of simplicity, transient states are not discussed in this prior art example. Input signal 24 at t < t₁ is zero and transistor 12 is switched off (i.e., does not conduct current between high-voltage source 22 and sensing resistor 14). Input signal 24 between t₁ ≤ t ≤ t₂ drives transistor 12 to switch to the ON state, thus enabling current to flow through transistor 12 (i.e., between drain and source terminals) as well as through sensing resistor 14. The current flowing through sensing resistor 14 (typically low-ohmic) produces a voltage drop V_{Rs} across sensing resistor 14. Voltage sensing sub-circuit 16, which is a series RC low-pass filter/integrator circuit, senses the voltage drop V_{Rs} and produces an output signal 26. By measuring output signal 26 and knowing the resistance of sensing resistor 14, the current flowing through the switch, i.e., transistor 12, as well as sensing resistor 14 is determined.

Several disadvantages of current sensing techniques that employ a series-connected sensing resistor as shown in Figure 1, may include time-accumulated energy losses (e.g., as heat) resulting from current flow through sensing resistor 14 (i.e., depending on the value of the current and resistor's value); the occurrences of unwanted inductances between transistor 12 and sensing resistor 14 that may cause inductive spikes; typically a low-voltage output signal (on the order of millivolts); minimal or no protection against high-voltages; as well as conduction losses exhibited by a reduction in V_{gs} (gate-to-source voltage) of transistor 12 caused by the voltage drop V_{Rs}.

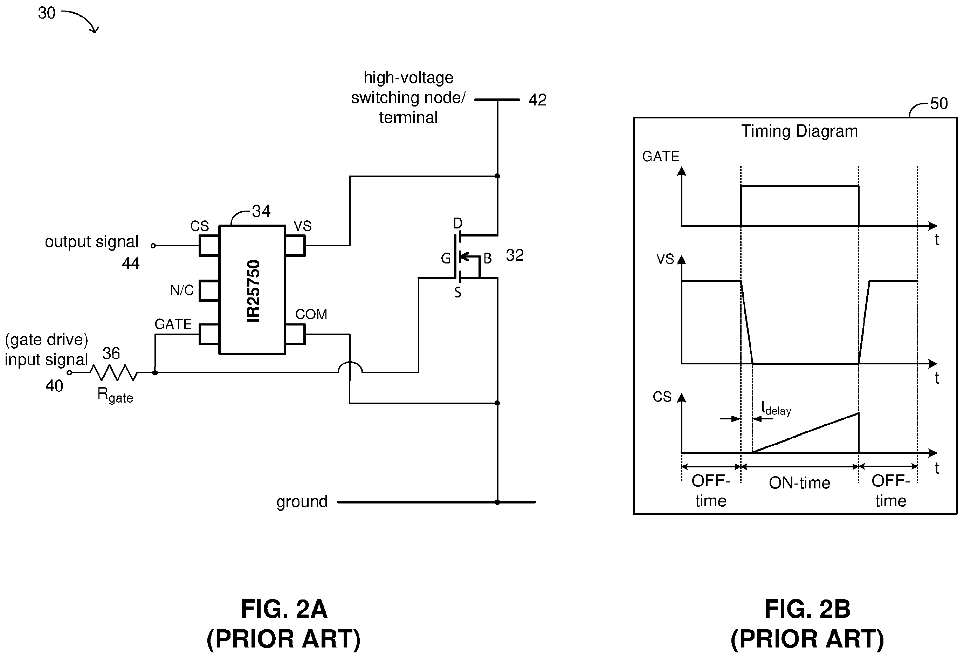

Another known prior art technique for sensing current employs a current sensing circuit or a dedicated integrated circuit (IC) that is connected in parallel to a power switch (e.g., switching transistor) through which the current that is intended for sensing flows. Reference is now made to Figures 2A and 2B. Figure 2A is a schematic illustration of a parallel-connected sensing circuit, generally referenced 30, for measuring current flow through a transistor-implemented switch, which is prior art. Figure 2B is a timing diagram, generally referenced 50, corresponding to the operation of the integrated circuit (IC) in the parallel-connected sensing circuit of Figure 2A. Circuit 30 (Figure 2A) includes a transistor 32, an integrated circuit (IC) 34, and a gate resistor 36. Transistor 32 is shown in Figure 2A to be a MOSFET; however, the same principles apply to IGBT. IC 34 is an IR25750 current sensing IC manufactured by International Rectifier Corporation (acquired by Infineon Technologies AG). IC 34 includes a CS pin (interchangeably herein "pin", "connector", and "terminal"), a GATE pin, a VS pin and a COM pin. The GATE terminal of IC 34 is connected to the gate terminal of transistor 32, as well as one end of gate resistor 36. The other end of gate resistor 36 is connected to a gate drive input signal terminal 40. The COM terminal is connected to the source terminal of transistor 32, which in turn is grounded. The VS terminal is connected to a high-voltage switching node/terminal 42. The CS terminal constitutes an output signal terminal 44.

Transistor 32 functions as a power switch, used to switch external devices and voltages (not shown) 'ON' and 'OFF'. The configuration described in conjunction with Figure 2A, shows that IC 34 is connected in parallel to the drain and source terminals of transistor 32. IC 34 is thus operative as a parallel-connected sensing circuit employed for measuring the voltage between drain and source terminals, i.e., VDS(on), of transistor 32 (in case transistor 32 is a MOSFET) or the voltage between collector and emitter terminals, i.e., VCE(on), in case transistor 32 is a IBGT. The internal circuitry (not shown, but available on-line) of IC 34 includes a MOSFET (HVFET), an RC-delay circuit, and a p-type metal-oxide-semiconductor (PMOS) hold-down transistor. The specifics of IR25750 including an internal circuitry diagram (not shown) and principles of operation may be found in *"Application Note AN-1199"* published by International Rectifier Corporation via www.ifr.com. IC 34 utilizes gate drive input signal 40 for powering and turning the internal circuitry on and off.

With further reference to timing diagram 50 of Figure 2B, during the 'OFF'-time of transistor 32, gate drive input signal 40 is 'low' (i.e., at COM), as well at the CS terminal. When gate drive input signal 40 turns to 'high' (rectangular waveform), transistor 32 is turned on and the drain voltage decreases from the high-voltage toward V_{DS}(on) that depends on the product of the current flowing through transistor 32 and its characteristic R_{DS}(on) (which is temperature-dependent). Subsequent to a brief time delay caused by the RC-delay circuit of IC 34, the HVFET turns on, the PMOS turns off and the drain voltage of transistor 32 is conducted via the HVFET to the CS output terminal of IC 34 as output signal 44. Gate resistor 36 enables IC 34 to turn on a brief time delay after the turn-on time of transistor 32. Output signal 44 at the CS output terminal is the target current sensing signal that can be fed to auxiliary circuits (not shown). Conversely, when gate drive input signal 40 changes to 'low', transistor 32 turns off, then the HVFET turns off, and the CS terminal is at COM.

Parallel-connected sensing circuit 30 (Figure 2A) is considered an advancement over the traditional series-connected resistor-sensing circuit 10 (Figure 1), however, both circuits may exhibit noise spikes as a result of the switching. Furthermore, in circuit 30, given that the output voltage V_{DS}(on) depends on the product of the current flowing through transistor 32 and R_{DS}(on), at least one of "high" current (e.g., 2 amperes) or relatively "high" R_{DS}(on) (e.g., 0.25 Ω) are required to produce an output voltage, *V*, on the order of roughly between 0.5 ≲ *V* ≲ 1 volts. Consequently, circuit 30 may require the use of an additional gain block (e.g., an amplifier), as well as utilization of temperature compensation and management techniques given the variation of V_{DS}(on) on temperature (i.e., ambient as well as self-heating).

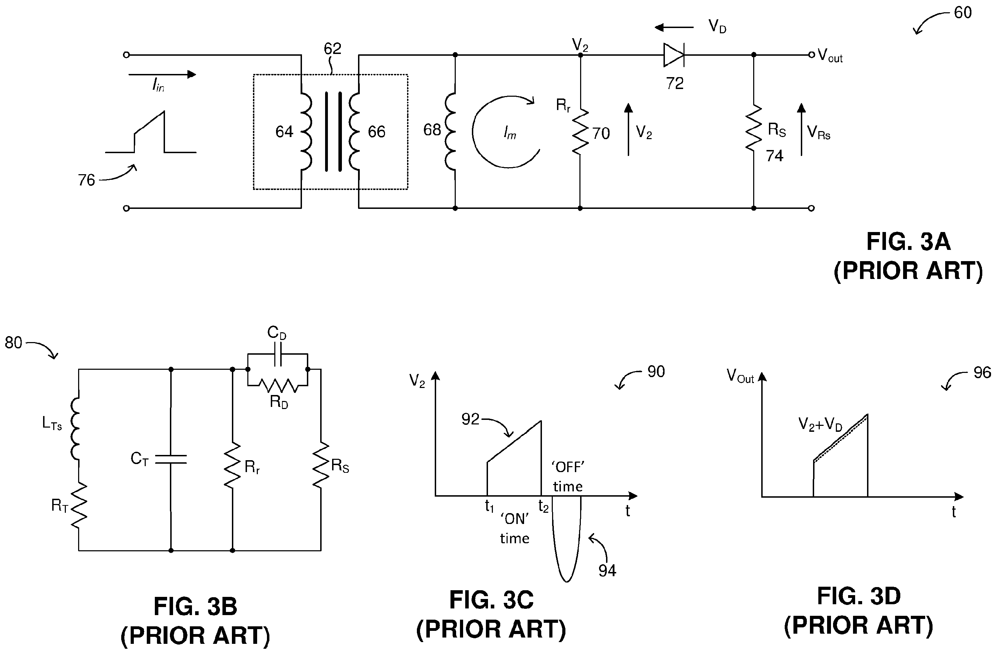

Another prior art technique for sensing current employs a current transformer connected to a sensing circuit that includes a sensing resistor through which the current that is intended for sensing flows. Reference is now made to Figures 3A, 3B, 3C, and 3D. Figure 3A is a schematic illustration of a current sensing circuit, generally referenced 60, employing a current transformer for measuring current flow, which is prior art. Figure 3B is a schematic illustration of a simplistic equivalent circuit, generally referenced 80, of part of the current sensing circuit of Figure 3A. Figure 3C is a schematic illustration of an intermediate output voltage waveform, generally referenced 90, corresponding to the operation of the current sensing circuit of Figure 3A. Figure 3D is a schematic illustration of an output voltage waveform, generally referenced 96, corresponding to the operation of the current sensing circuit of Figure 3A. Current sensing circuit 60 (Figure 3A) includes a current transformer 62, a diode 72, a reset resistor 70, and a sensing resistor 74 (Rₛ). Current transformer 62 includes a primary winding 64 (e.g., with one winding) electromagnetically coupled with a secondary winding 66 (e.g., typically a plurality of windings). The inductance of the secondary winding is represented by an inductor 68 (while its parasitic capacitance (i.e., between its windings)) is not shown in Figure 3A. The anode of diode 72 is connected to one terminal of secondary winding 66, while the cathode of diode 72 is connected to sensing resistor 74, which in turn completes a closed circuit with the second terminal of secondary winding 66.

A time-varying input current 76, denoted *Iᵢₙ*, (e.g., a pulse) flows through primary winding 64 thereby generating a voltage, which in turn electromagnetically induces an induced voltage in secondary winding 66, i.e., a voltage V₂, as shown in Figure 3C and represented by an intermediate output voltage waveform 90. Reset resistor 70 is employed to allow time for resetting the intermediate output voltage V₂ (following each input pulse) so that transformer 62 doesn't saturate. Figure 3B shows an equivalent circuit 80 of part of current sensing circuit 60 of Figure 3A. Equivalent circuit 80 represents particular non-ideal aspects of a non-ideal transformer 62 whose secondary winding 66 (as well as primary winding 64) exhibits an electrical resistance, represented by a resistor R_{T}, and parasitic capacitances (i.e., between its windings), represented by an equivalent capacitor C_{T}. Figure 3B further shows inductance 68 of secondary winding 66, represented by an inductor L_{Ts}, a capacitance of diode 72, represented by a capacitor C_{D}, a resistance of diode 72, represented by a resistor R_{D}, (as well as reset resistor Rᵣ, and sensing resistor R_{S}). An 'ON' time, between t₁ and t₂ (Figure 3C), corresponding to an ON-time of input current *Iᵢₙ* (Figure 3A), is characterized by a current flow *Iₘ* through reset resistor 70, and a positive component 92 of voltage V₂ of intermediate output voltage waveform 90 (Figure 3C). An 'OFF' time of input current *Iᵢₙ* is characterized by a current flow in an opposite direction to *Iₘ,* in sub-circuits formed by components L_{Ts}, R_{T}, C_{T} and Rᵣ in equivalent circuit 80, and a negative component 94 of voltage V₂ of intermediate output voltage waveform 90. Diode 72 rectifies negative component 94 of intermediate output voltage waveform 90. An output voltage V_{Out} (Figures 3A, 3D) is a sum of voltage V₂ and a forward voltage drop on diode 72, denoted by V_{D} (i.e., Vₒᵤₜ = V₂+V_{D}), as represented by output voltage waveform 96. The (resistance) value of reset resistor 70 is typically selected such that it is not much greater than the value of R_{T}, otherwise if *Rᵣ* >> *R_{T}* most of current *Iₘ* would effectively flow through secondary winding 66. Furthermore, the value of sensing resistor 74 is typically selected such that it is not much greater than the value of reset resistor 70, otherwise if *Rₛ* >> *Rᵣ* most of current flow would occur through reset resistor 70. Consequently, the product of low-valued resistance of sensing resistor 70 with low-valued current flowing therethrough produces a low-valued voltage drop on sensing resistor 70, thus typically requiring the amplification of output voltage V_{Out}.

Methods and devices for sensing voltage and current, in general, are known in the prior art. For example, patent publication no.: DE 19753033 A1, titled "Method and device for measuring electromagnetic compatibility", is directed at a device for measuring electromagnetic compatibility in accordance with a European standard (ENV 50142). The device and method involve a transformer used to couple voltage pulses from an object under test to simulation or operator equipment. This method and device can be used in measurements of electromagnetic compatibility and is particularly useful for shielded cables.

Patent publication no.: JP H01153734, titled "Pulse signal transmission circuit", is directed at an isolated pulse signal circuit for detecting rising and falling edges of an input pulse signal for low-power applications. Particularly, a shunt circuit is disclosed that includes a transformer whose primary inductor is connected to a pulse signal via a resistor, and its secondary inductor is connected to a converter via two resistors.

Patent publication no.: DE 102008009888 A1 is directed at a switching arrangement for bi-directional measurement of unipolar currents, having a transformer. The switching arrangement includes a transformer, two bipolar transistors, two diodes, and two resistors. The two bipolar transistors and two diodes are connected to a secondary winding branch of a transformer circuit. The first bipolar transistor and first diode form a first active switch for passing a measuring current in a first direction. The second bipolar transistor and second diode form a second active switch for passing a measuring current in a second direction. A load is connected at a junction where two anode terminals of the two diodes are connected for the purpose of passing the measuring current with the former and latter directions and producing a measuring signal. This arrangement allows for bi-directional measurement of unipolar currents.

Patent publication no.: JP 2001111390 A, titled "Pulse isolator" is generally directed at a pulse isolator for transmitting a pulse signal in a wide frequency range (0.00001 Hz to 100 MHz) by separating (isolating) the input and output using a pulse transformer and among other elements, a flip-flop circuit. A capacitor is connected in series with a buffer, as well as with a primary winding of the transformer. One terminal of the capacitor is connected with one terminal of the primary winding of the transformer, while the other terminal of the capacitor is connected to the output terminal of buffer. The flip-flop circuit is coupled at the output side (secondary winding) of the transformer. The pulse transformer is used for pulse signal transmission instead of optocouplers for the purpose of reducing power consumption and cost.

U.S. Patent Application Publication No.: US 2002/0150140 A1, titled "Inductively Coupled Thermistors and Other Sensors" is directed at systems and methods for inductively measuring environmental parameters, such as temperature, at one side and beyond a barrier (without having to make a hole in the barrier) using an inductively coupled thermistor. The system includes an active circuit disposed outside a refrigerator housing, and a passive circuit disposed inside a refrigerator housing. The active circuit essentially includes a primary transformer coil, a resistor, a pulse generator, and a measuring circuit. The passive circuit includes a secondary transformer coil coupled to a thermistor. An RCL resonant circuit is formed by a capacitor connected via a resistor to the primary transformer coil. The resistor is further connected to a positive input of an operational amplifier. The measuring circuit converts a peak current value into a value corresponding to the temperature surrounding the thermistor.

Patent publication no.: DE 102014014682 A1 entitled "Circuit arrangement for transmitting a DC voltage to be measured to a galvanically separated evaluation unit" is directed at a circuit arrangement that enables to transmit a DC voltage to be measured, such as for monitoring charge/discharge state of a battery, by using a transformer for galvanic isolation (inductive separation) of an evaluation unit. The circuit arrangement includes a transformer with a transmission ratio of 1:1, having a primary winding connecting to the DC voltage to be measured, in an amplitude-modulated first AC voltage, and a secondary winding connecting to an output stage that converts a second AC voltage generated in the secondary winding with the aid of a synchronous rectifier in one of the DC voltages to be measured.

### SUMMARY OF THE PRESENT DISCLOSED TECHNIQUE

It is an object of the disclosed technique to provide a novel device for at least one of detecting and measuring a pulsed voltage source. The device includes a transformer, and a differentiator. The transformer has a primary winding electromagnetically coupled with a secondary winding. The primary winding has a first inductance. The differentiator includes at least one resistive element (e.g., a resistor) coupled with the primary winding, thereby forming a closed circuit with the pulsed voltage source. The differentiator is configured to electromagnetically induce an induced pulsed voltage on the secondary winding, such that the induced pulsed voltage is indicative of the pulsed voltage source.

In accordance with another aspect of the disclosed technique it is thus provided a device for at least one of detecting and measuring a pulsed voltage source. The device includes a differentiator, and a transformer. The differentiator includes at least one resistive element (e.g., a resistor) coupled with at least one capacitive element (e.g., capacitor), thereby forming a closed circuit with the pulsed voltage source. The transformer has a primary winding electromagnetically coupled with a secondary winding. The primary winding is connected in parallel to the at least one resistive element. The primary winding is configured to electromagnetically induce an induced pulsed voltage on the secondary winding, such that the induced pulsed voltage is indicative of the pulsed voltage source.

In accordance with a further aspect of the disclosed technique, there is thus provided a device for at least one of detecting and measuring a pulsed voltage source. The device includes a transformer having a primary winding electromagnetically coupled with a secondary winding. The primary winding has a first inductance. The resonant circuit includes at least one capacitive element (e.g., a capacitor) forming an LC circuit with the primary winding. The resonant circuit forms a closed circuit with the pulsed voltage source. The primary winding is configured to electromagnetically induce an induced pulsed voltage on the secondary winding, such that the induced pulsed voltage is indicative of the pulsed voltage source.

In accordance with another aspect of the disclosed technique, there is thus provided a method for at least one of detecting and measuring a pulsed voltage source. The method includes differentiating a pulsed signal of the pulsed voltage source via a differentiator, up-converting the differentiated signal, and at least one of detecting and measuring the up-converted differentiated signal. The differentiator has an inductive component that is a winding of a transformer, such that the differentiating generates a differentiated signal. The up-conversion of the differentiated signal via the transformer generates an up-converted differentiated signal. The up-converted differentiated signal is indicative of the pulsed voltage source.

### BRIEF DESCRIPTION OF THE DRAWINGS

The disclosed technique will be understood and appreciated more fully from the following detailed description taken in conjunction with the drawings in which:
Figure 1 is a schematic illustration of a series-connected sensing circuit for measuring current flow through a transistor-implemented switch, which is prior art;
Figure 2A is a schematic illustration of a parallel-connected sensing circuit, for measuring current flow through a transistor-implemented switch, which is prior art;
Figure 2B is a timing diagram corresponding to the operation of the integrated circuit (IC) in the parallel-connected sensing circuit of Figure 2A;
Figure 3A is a schematic illustration of a current sensing circuit employing a current transformer, for measuring current flow, which is prior art;
Figure 3B is a schematic illustration of a simplistic equivalent circuit, of part of the current sensing circuit of Figure 3A;
Figure 3C is a schematic illustration of an intermediate output voltage waveform, corresponding to the operation of the current sensing circuit of Figure 3A;
Figure 3D is a schematic illustration of an output voltage waveform, corresponding to the operation of the current sensing circuit of Figure 3A;
Figure 4A is a schematic illustration of a device for derivative voltage and current sensing of a pulsed voltage source, constructed and operative in accordance with an embodiment of the disclosed technique;
Figure 4B is a schematic illustration of a basic equivalent circuit of the device of Figure 4A, according to the disclosed technique;
Figure 4C is a schematic illustration of a characteristic plot of an output voltage as a function of time, plotted along with a plot of an input time-dependent pulsed signal of the voltage source, according to the disclosed technique;
Figure 5 is a schematic illustration of an example implementation of device 100, for derivative voltage and current sensing of and through a transistor-implemented-switch used for switching voltages and currents, according to the disclosed technique;
Figure 6A is a schematic diagram of a device for derivative voltage and current sensing of a pulsed voltage source, constructed and operative in accordance with another embodiment of the disclosed technique;
Figure 6B is a schematic diagram of a simulation circuit of the device illustrated in Figure 6A, constructed and operative according with the embodiment of the disclosed technique;
Figure 6C is a plot of an output voltage produced by the simulation circuit of Figure 6B;
Figure 6D is a plot of the output voltage of the simulation circuit of Figure 6B as a function of rise time of the input voltage of the pulsed voltage source;
Figure 6E is a plot of the output voltage of the simulation circuit of Figure 6B as a function the value of the capacitor of the device of Figure 6A;
Figure 7 is a schematic diagram of a device for derivative voltage and current sensing of a pulsed voltage source, constructed and operative in accordance with a further embodiment of the disclosed technique;
Figure 8A is a schematic diagram of a device utilizing a resonant circuit for derivative voltage and current sensing of a pulsed voltage source, constructed and operative in accordance with another embodiment of the disclosed technique;
Figure 8B is a schematic illustration of a basic model of an equivalent circuit of the resonant circuit of the device in Figure 8A;
Figure 8C is a schematic illustration of a characteristic plot of an input time-dependent pulsed signal of the voltage source;
Figure 8D is a characteristic plot of a time-dependent voltage drop on the primary winding of the transformer according to a first model configuration of the resonant circuit of the device of Figure 8A;
Figure 8E is a characteristic plot of a time-dependent voltage drop on the primary winding of the transformer according to a second model configuration of the resonant circuit of the device of Figure 8A;
Figure 8F is a characteristic plot of an output voltage as a function of time of the device of Figure 8A, in accordance with the embodiment of the disclosed technique;
Figure 9A is a schematic diagram of an example implementation of an auxiliary output detection and measurement comparator circuit, configured to be used with the devices of the disclosed technique;
Figure 9B is a schematic diagram of another example implementation, of an auxiliary output peak/envelope detector circuit, configured to be used with the devices of the disclosed technique;
Figure 9C is a schematic diagram of a further example implementation, of an auxiliary output comparator peak detector, configured to be used with the devices of the disclosed technique; and
Figure 10 is a schematic diagram of a method for at least one of detecting and measuring a pulsed voltage source, in accordance with the principles of the disclosed technique.

### DETAILED DESCRIPTION OF THE EMBODIMENTS

The disclosed technique overcomes the disadvantages of the prior art by providing a device for at least one of detecting and measuring, in a derivative manner, at least one of: (1) voltage of; and (2) current flowing through, a voltage source, through an "unconventional" use of a transformer, which will be explained in detail. A transformer is generally a device that is configured and operative to transfer electrical energy between at least two circuits via electromagnetic induction. Several ubiquitous conventional uses of transformers include stepping-down and stepping-up of voltage and current, electrical isolation between circuits, impedance matching, signal filtering, alternating current (AC) phase angle regulation, etc. The disclosed technique uses a transformer, simultaneously in a conventional manner (i.e., for transferring electrical energy between circuits), as well as, and more importantly, in an unconventional manner. Given a transformer that includes a primary winding and a secondary winding that are electromagnetically coupled with each other, the transformer is configured for transferring electrical energy between primary and secondary windings (i.e., depending on the characteristics of the applied energy source to at least one of the windings). The unconventional use of the transformer, according to one embodiment of the disclosed technique, involves utilizing the primary winding as the inductive element in a differentiator circuit. Hence, the primary winding is a dual-use shared main component of both the transformer and the differentiator circuit. According to another embodiment of the disclosed technique the primary winding is the inductive element in a resonant circuit.

Specifically, according to one embodiment of the disclosed technique, there is thus provided a device for at least one of detecting and measuring a voltage source that is pulsed (i.e., also denoted herein interchangeably "pulsed voltage source") that is characterized as not having a constant voltage over time. The device includes a transformer and a differentiator. The transformer includes a primary winding (that has a first inductance) electromagnetically coupled with a secondary winding. The differentiator includes at least one resistive element (e.g., a resistor, a plurality of resistors having an effective electrical resistance) coupled with the primary winding, thereby forming a closed circuit with the pulsed voltage source. Thus, the main inductive component of the differentiator is common with part of the transformer, namely, its primary winding. The differentiator is configured to electromagnetically induce an induced pulsed voltage (i.e., a pulsed voltage that has been electromagnetically induced via the principles of electromagnetic induction) on the secondary winding, where the induced pulsed voltage is indicative of the pulsed voltage source.

The disclosed technique generally addresses a need to provide voltage and current sensing in power electronics systems for the purposes of measurement (e.g., deriving data), control (e.g., power regulation, feedback, etc.), monitoring (e.g., self-monitoring of a power supply circuit), as well as protection and safety (e.g., for preventing overloading conditions, short-circuits, etc.). For example, there is a need to acquire information pertaining to current flow through a particular high-voltage switching device (e.g., a high-voltage transistor, or a series of interconnected high-voltage switching transistors).

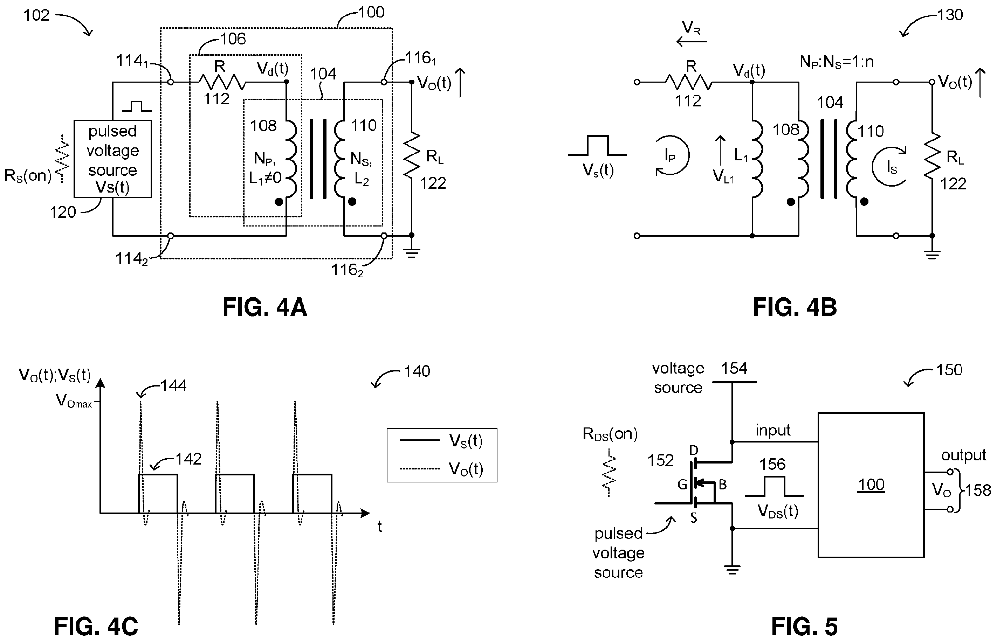

To further disclose in greater detail this embodiment of the disclosed technique, reference is now made to Figures 4A, 4B, and 4C. Figure 4A is a schematic illustration of a device, generally referenced 100, for derivative voltage and current sensing of a pulsed voltage source, constructed and operative in accordance with an embodiment of the disclosed technique. Figure 4B is a schematic illustration of a basic equivalent circuit, generally referenced 130, of the device of Figure 4A, according to the disclosed technique. Figure 4C is an illustration, generally referenced 140, of a characteristic plot of an output voltage as a function of time, plotted along with a plot of an input time-dependent pulsed signal of the voltage source, according to the disclosed technique. Device 100 includes a transformer 104 and a differentiator 106. Transformer 104 includes a primary winding 108, and a secondary winding 110, in which the primary and secondary windings are electromagnetically coupled with each other. Primary winding 108 includes N_{P} winding(s), and has a first inductance, L₁ (that is non-zero). Secondary winding 110 includes N_{S} winding(s), and has a second inductance, L₂ (that can be zero). (N_{P} and N_{S} are numbers.) Differentiator 106 includes at least one (electrical) resistive element represented by a resistor 112 coupled to primary winding 108. Hence, the main inductive component in differentiator 106, namely, primary winding 108, is also part of transformer 104. Device 100 further includes input terminals 114₁ and 114₂ and output terminals 116₁ and 116₂, as shown in Figure 4A. Device 100 is configured and operative to be coupled via input terminals 114₁ and 114₂ with an external, time-varying voltage source 120 that is pulsed ("pulsed voltage source"), denoted by Vs(t) and characterized by having an internal resistance during an 'ON' state, denoted herein as Rₛ(on). Differentiator 106 and specifically the series-coupled pair of resistor 112 and primary winding 108 is configured to form a closed circuit with pulsed voltage source 120, as shown in Figure 4A. Differentiator 106 is configured and operative to electromagnetically induce an induced pulsed voltage on secondary winding 110, such that the induced pulsed voltage is indicative of pulsed voltage source 120, as will be described in detail hereinbelow. Additionally, device 100, and specifically secondary inductor 110 are configured and operative to be coupled, via output terminals 116₁ and 116₂ with an external load 122 (R_{L}), i.e., a "sensing load" (e.g., a shunt resistor ("sensing resistor" or "resistive load") through which current flows and can be detected and measured. Device 100 including peripherals elements such as voltage source 120 and external load 122 are collectively referenced 102 in Figure 4A. Note that the at least one resistive element, effectively represented by resistor 112 can embody a single resistor, a plurality of resistors (in series and/or in parallel), an impedance (i.e., an ohmic resistance component and reactance component), or an equivalent device that exhibits electrical resistance, which is compatible with the principles of the disclosed technique.

Figure 4B illustrates a basic equivalent circuit 130 of device 100 (Figure 4A) where voltage source 120 is configured to apply a pulsed signal 142 (Figure 4C) to the series RL circuit of differentiator 106 (Figures 4A, 4B) thus forming a closed circuit through which a current I_{P} flows (Figure 4B). Pulsed signal 142 is a time-varying signal whose waveform includes rising and falling edges. Although pulsed signal 142 is shown in Figure 4C to be rectangular, other pulse shapes (e.g., that have rising and falling edges) are also viable. Further note that for the purpose of elucidating the main principles of the disclosed technique, basic equivalent circuit 130 shows a simplistic model that does not cover an equivalent sub-circuit of a "real" (i.e., non-ideal) transformer that exhibits leakage reactance, core losses (or magnetizing current losses such as hysteresis), flux leakage, parasitic capacitances, etc. The resistance of resistor 112 is denoted R, and the non-zero inductance of inductor 108 is denoted L₁. The (time-dependent) voltage drop on resistor 112 is denoted V_{R}(t) (V_{R} for brevity), and the voltage drop on inductor 108 is denoted V_{L1}(t) (V_{L1}, for brevity), such that the following equation holds: ${V}_{S} = {V}_{R} + {V}_{{L}_{1}}$ (1). The voltage at the R-L coupling point, denoted V_{d}(t) (V_{d}, for brevity), which is also equal to V_{L1}, is determined by solving the differential equation: ${V}_{S} = {I}_{P} R + {L}_{1} \frac{{dI}_{P}}{dt}$ (2). The time-varying current I_{P} in inductor 108 produces a varying magnetic field (not shown) whose flux propagates also through inductor 110 thereby producing a varying voltage (i.e., an electromotive force (emf)) at inductor 110. An output voltage ("induced voltage"), V_{O}(t), is thus produced between the terminals of inductor 110 through electromagnetic induction, where the maximum output voltage, i.e., *V_{Oₘₐₓ}* = *max* {*V₀*(*t*)}, is given (ideally) by: ${V}_{{O}_{max}} = \frac{{N}_{S}}{{N}_{P}} {V}_{{L}_{1 max}} = {nV}_{{L}_{1 max}} = n \left({V}_{Smax}-{V}_{Rmin}\right)$ (3), where n denotes the turns ratio of transformer 104 that has a conversion factor proportional to *n* (e.g., step-up ("up-conversion": *n* > 1), step-down ("down-conversion": *n* < 1), 1:1 conversion: (*n* = 1)). The maximum output voltage, *V_{Oₘₐₓ}* is thus *n* times the maximum voltage on inductor 108, i.e., V_{L1} = V_{d}, (taking into account the voltage drop on resistor 112, V_{R}, whose minimal value is denoted by *V_{Rmin}*). *V_{Oₘₐₓ}* is thus indicative of the voltage of pulsed voltage source 120 (i.e., the output signal V_{O}(t) serving as an indication or gage that is dependent upon the input signal Vₛ(t)). Figure 4C shows a characteristic plot of output voltage V_{O}(t) as a function of time, denoted by 144, plotted along with a plot of the time-dependent input pulsed signal 142 of voltage source 120. For measuring the current, I_{S}, secondary inductor 110 is configured and operative for coupling with sensing load R_{L}, for example, in the form of sensing resistor 122. Current I_{S} can be detected and measured via current measuring devices (not shown) (e.g., a current detection circuit, an ammeter, and the like). Alternatively, by measuring the output voltage V_{O}(t), and knowing the value of sensing resistor 122, the current I_{S} is determined (e.g., via Ohm's law) (i.e., current flow through sensing resistor 112). Device 100 does not necessitate the use of amplifiers for amplifying an output voltage V_{O}(t) signal (i.e., as may conventionally be required in prior art devices), since *V_{Oₘₐₓ}* is typically on the order of volts. For example, given *n* = 100, and a peak voltage *V_{d}* ≈ 5 mV, the ideal (i.e., without energy losses), and for a negligible voltage drop on resistor 112 (V_{R}), the maximum output voltage *V_{Oₘₐₓ}*≈ 5V (i.e., on the order of volts).

Device 100 is implemented for derivative voltage and current sensing of a pulsed voltage source that is a switching device (or equivalents thereof). For example, the switching device is configured and operative to rapidly turn on and off a voltage source connected thereto, such that the switching device itself effectively becomes a source of pulsed voltage, as referred herein "pulsed voltage source". The switching device may be embodied in the form of an electronic switch such as a switching circuit, a transistor (e.g., bipolar, metal-oxide-semiconductor field-effect transistor (MOSFET), insulated gate bipolar transistor (IGBT), etc.), a silicon-controlled rectifier (SCR), a triode alternating current (TRIAC) switch, a diode alternating current (DIAC) switch, an electromagnetic switch such as a relay, a mechanical switch such as a toggle switch, push-button switch, as well as a physical-property dependent switch (i.e., of different physical properties such as pressure, temperature, magnetic field, light intensity, such as in a pressure-dependent switch, a temperature-dependent switch, a magnetic field dependent switch, a light intensity dependent switch, etc.), and the like. Alternatively, the pulsed voltage of pulsed voltage source is generated by a current flowing through a resistive element (e.g., a resistor, a resistive load, a sensing resistor etc.), thereby producing a voltage drop on the resistive element. This resistive element constitutes an internal resistance in an 'ON' state (Rₛ(on)) (e.g., of a switching device such as a Silicon (Si) MOSFET, Gallium Nitride (GaN) high electron mobility transistor (HEMT), and the like). According to a particular implementation, the current flow through the sensing resistor is due to it being connected in series with the switching device (i.e., pulsed voltage source). To further detail this exemplary implementation, reference is now further made to Figure 5, which is a schematic illustration of an example implementation of device 100, generally referenced 150, for derivative voltage and current sensing of and through a transistor-implemented-switch used for switching voltages and currents, according to the disclosed technique.

Figure 5 shows example implementation 150 of device 100 (Figure 4A) whereby the input of device 100 is coupled to a transistor-implemented-switch that is embodied in this example (and without loss of generality) as a MOSFET 152. MOSFET 152 includes a gate terminal (G), a body terminal (B), a drain terminal (D), and a source terminal (S). Specifically, input terminals 114₁ and 114₂ (Figure 4A) of device 100 are respectively connected to drain and source terminals of MOSFET 152. The drain terminal of MOSFET 152 is connected to a voltage source 154, and the source terminal is grounded. MOSFET 152 is configured and operative as a (voltage-controlled) switch between an 'OFF' state (i.e., no conduction between drain and source terminals), and an 'ON' state (i.e., enabled for conduction between drain and source terminals), according to an externally-controlled gate-to-source voltage (V_{GS}) signal (not shown). During the OFF state of MOSFET 152, there's no conduction between drain and source terminals, and in effect, the switch is open and no current flows between voltage source 154 and the ground, as well as to device 100. In a transition from the OFF state to the ON state of MOSFET 152, current begins to flow between the drain and source terminals and device 100 receives a voltage pulse 156 as input (e.g., having a rising edge from a 'high' voltage (absolute) value to a 'low' voltage (absolute) value), via input terminals 114₁ and 114₂ (Figure 4A). When MOSFET 152 is in the ON state, it is characterized by an internal resistance denoted herein as R_{DS}(on), which depends on the transistor type, and other factors such as temperature. A typical example value is R_{DS}(on) ≈ 1 mΩ. The internal resistance during the ON state, R_{DS}(on), causes a voltage drop V_{DS}(on) on MOSFET 152, which in turn device 100 senses via the rising edge of voltage pulse 156. Similarly, in a transition from the ON state to the OFF state of MOSFET 152, current ceases to flow between the drain and source terminals, and voltage pulse 156 turns from 'high' to 'low'. Device 100 senses the plummeting voltage drop on MOSFET 152 through the falling edge of voltage pulse 156. As explicated hereinabove in conjunction with Figures 4A, 4B, and 4C, voltage pulse 156 (Figure 5) of the pulsed voltage source produces a corresponding voltage V_{d} = V_{L1} at the terminals of inductor 108, which in turn induces a corresponding induced pulsed voltage at secondary inductor 110 that is indicative of voltage pulse 156. In accordance with the disclosed technique, by using equation (3) where *V_{S} = V_{DS},* knowing the values of R_{DS}(on) and R of resistor 112, as well as by measuring an output 158, V_{O}, from device 100, the current *I* flowing through MOSFET 152 is determined according to: ${V}_{{O}_{max}} = I ⋅ {R}_{eq} \left(on\right) ⋅ n \approx I ⋅ {R}_{DS} \left(on\right) ⋅ n = {V}_{DS} \left(on\right) ⋅ n$ (4), where *R_{eq}*(*on*) denotes an equivalent resistance of a sub-circuit that includes R_{DS}(on), R (of resistor 112), and R_{L1} (ohmic resistance of inductor 108, which is typically very low). Typically, *R_{DS}*(*on*) is approximately equal to *R_{eq}*(*on*) (i.e., *R_{DS}*(*on*) ≈ *R_{eq}*(*on*) to about one in one-thousandth. For example, given R_{DS}(on) = 1 mΩ, R = 100Ω, and R_{L1} = 1Ω, yields: *R_{eq}*(*on*) ≈ 0.999 mΩ. In effect, most of the current, *I*, flows through MOSFET 152 owing to its relatively low (on)-resistance value. In this manner, device 100 is configured and operative for derivative voltage and current sensing of voltage pulse 156 of a pulsed voltage source, in this case a switching device that is MOSFET 152. Output voltage 158 is therefore also indicative of current flowing through the pulsed voltage source (i.e., in this example, a transistor-implemented switch, which is MOSFET 152).

In an alternative configuration (not shown), MOSFET 152 is replaced by a small-valued sensing resistor (not shown), such that voltage source 154 is connected to the sensing resistor, and is configured and operative as a source of pulsed voltage. The sensing resistor can be selected to have typical equivalent values of R_{DS}(on) corresponding to that of MOSFET 152, or alternatively, other values. The same principles of the disclosed technique detailed hereinabove apply to this alternative configuration.

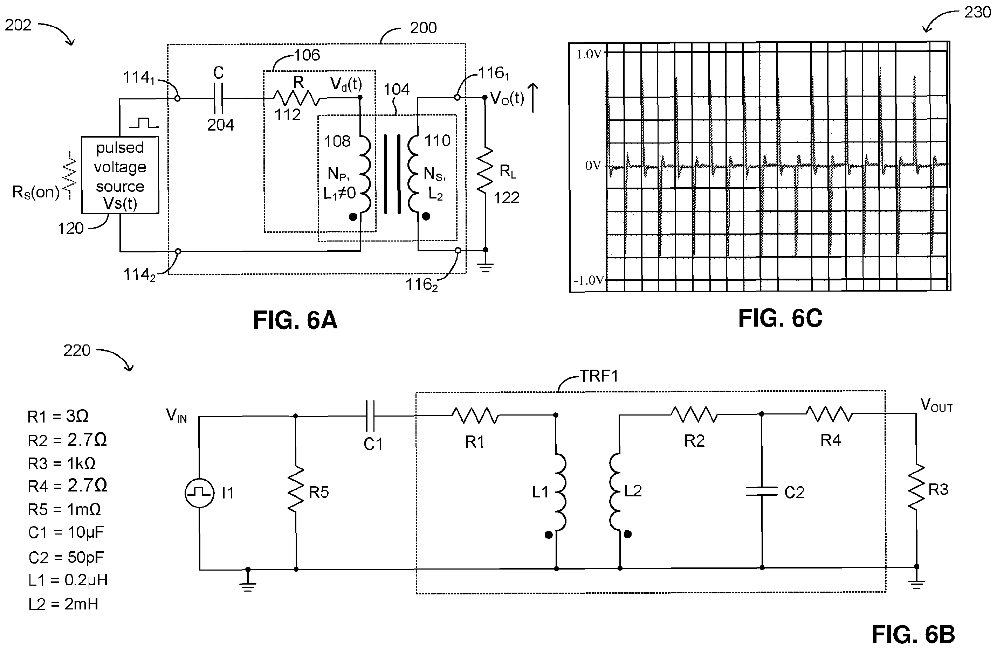

According to another embodiment of the disclosed technique, there is thus provided a direct current (DC) filter and high-voltage (HV) protector that is configured for coupling between the resistor of the differentiator and the pulsed voltage source. The DC filter and HV protector may be implemented, for example, by a capacitor. To further detail this embodiment, reference is now made to Figures 6A, 6B, and 6C. Figure 6A is a schematic diagram of a device for derivative voltage and current sensing of a pulsed voltage source, constructed and operative in accordance with another embodiment of the disclosed technique. Figure 6B is a schematic diagram of a simulation circuit of the device illustrated in Figure 6A, constructed and operative according with the embodiment of the disclosed technique. Figure 6C is a plot, generally referenced 230, of an output voltage produced by the simulation circuit of Figure 6B. Device 200 (Figure 6A) is basically the same as device 100 (Figure 4A) with all components and their respective reference numbers remaining the same, apart from the inclusion of a capacitor 204 in device 200. Device 200 is implemented for derivative voltage and current sensing of a pulsed voltage source (or equivalents thereof, such as a switching device). Device 200 including peripherals elements such as voltage source 120 and external load 122 are collectively referenced 202 in Figure 6A. One terminal of capacitor 204 is connected to resistor 112, while another terminal is connected to pulsed voltage source 120. Capacitor 204 is a DC decoupler configured and operative to filter out (i.e., block) DC components (i.e., at least one time-unvarying DC component) of a pulsed voltage source signal (thus averting potential transformer saturation), as well as to provide (to a certain extent) HV protection to device 200. Since differentiator 106 effectively produces an output signal from the time-varying signal components of the pulsed voltage source signal, the time-unvarying DC components of the pulsed voltage source signal can be filtered out by capacitor 204. Should the pulsed voltage source signal include high-voltage DC components, capacitor is configured and operative to provide HV protection to the rest of device 200, by filtering out such high-voltages. The capacitance value of capacitor 204 is selected according to the characteristics of the pulsed voltage source signal. Furthermore, in the case where pulsed voltage source 120 produces repeating periodic pulses, the capacitive reactance of capacitor 204, denoted X_{c} is inversely proportional to a frequency, *f*, of pulsed voltage source 120, according to: *X_{C}* = -1/(2*πfC*) such that it's reactance decreases (in absolute terms) with increasing frequency. Hence, for a given capacitance C of capacitor 204, the higher the value of *f*, the lower the value of X_{c} will be.

Figure 6B shows a simulation circuit, generally referenced 220, of device 200 (Figure 6A), in which pulsed voltage source 120 is simulated by 11 and resistor R5, capacitor 204 (Figure 6A) is simulated by capacitor C1 (Figure 6B), transformer 104 (Figure 6A) is simulated by a transformer equivalent simulation sub-circuit TRF1 (Figure 6B), and load resistor 122 (Figure 6A) is simulated by resistor R3. Transformer equivalent simulation sub-circuit includes inductor L1 (simulating primary winding 108), inductor L2 (simulating secondary inductor 110), resistor R1 (simulating resistor 112), a resistor R2, capacitor C2 and resistor R4 simulating the resistances and parasitic capacitance of transformer 104. Further noted is that real (i.e., non-ideal) transformers exhibit a coupling coefficient that is typically k < 1. Typical values used in simulation circuit 220 are shown in Figure 6B. Plot 230 in Figure 6C shows output voltage produced by the simulation circuit of Figure 6B, at "V_{OUT}". The peak-to-peak output voltage is approximately 1.6 volts, thus obviating the need to use amplifiers at the output.

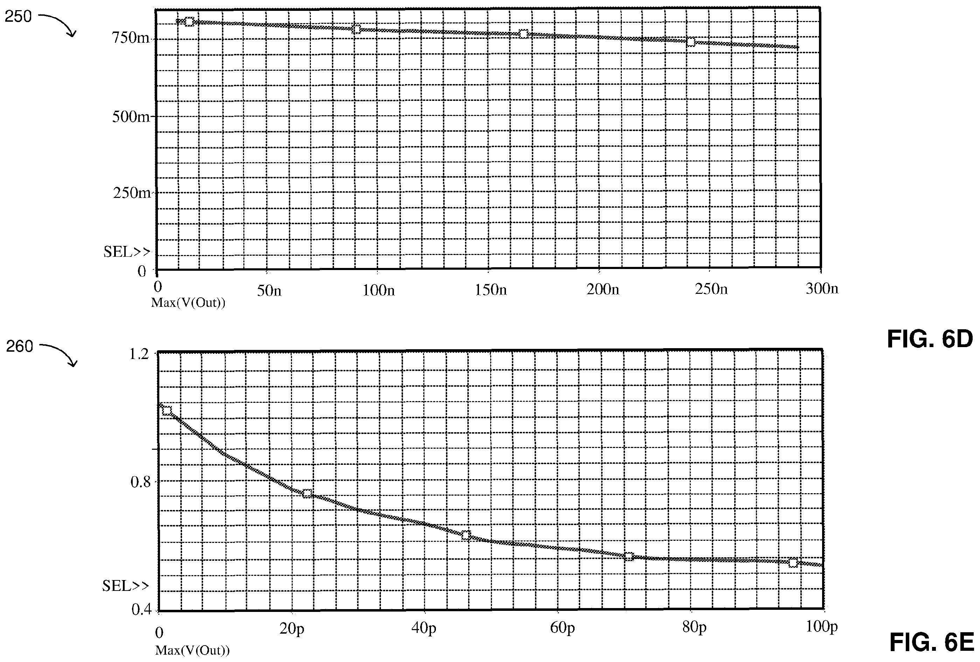

The output voltage V_{OUT} (Figure 6B) is generally dependent upon the rise time(s) of the input voltage V_{IN} of pulsed voltage source I1. To further illustrate this dependence, reference is now further made to Figure 6D, which is a plot, generally referenced 250, of the output voltage V_{OUT} of the simulation circuit of Figure 6B as a function of rise time of the input voltage V_{IN} of the pulsed voltage source. Plot 250 shows output voltage (in millivolts) on the vertical axis as a function of time (in nanoseconds) on the horizontal axis. The data points in plot 250 demonstrate a rather flat (i.e., slight) sensitivity or dependence of the output voltage V_{OUT} as a function of rise time of the input voltage V_{IN} of pulsed voltage source 11. In general, the output voltage decreases with increasing rise times of the (input) pulsed voltage source. In the example plot shown in Figure 6D the value of capacitor C1 was 30pF. Although the range of rise times shown is between 0 (not including) and 300 ns., (i.e., tᵣ = (0,300]) devices 100 (Figure 4A) and 200 (Figure 6A) of the disclosed technique may typically employ a much narrow range of rise times e.g., tᵣ = (0, 100 ns.], where the output voltage is only marginally dependent on the rise time.

The output voltage V_{OUT} (Figure 6B) is also generally dependent on the value of capacitor 204 (Figure 6A) or C1 (Figure 6B). To further illustrate this dependence, reference is now further made to Figure 6E, which is a plot, generally referenced 260, of the output voltage V_{OUT} of the simulation circuit of Figure 6B as a function the value of the capacitor of the device of Figure 6A. Plot 260 shows output voltage (in volts) on the vertical axis as a function of capacitance of capacitor C1 (Figure 6C) (in picofarads) on the horizontal axis. The data points in plot 260 generally demonstrate that the output voltage decreases with increasing capacitance values of capacitor C1. In the example plot shown in Figure 6E the rise time of pulsed voltage source 11 was tᵣ = 100ns.

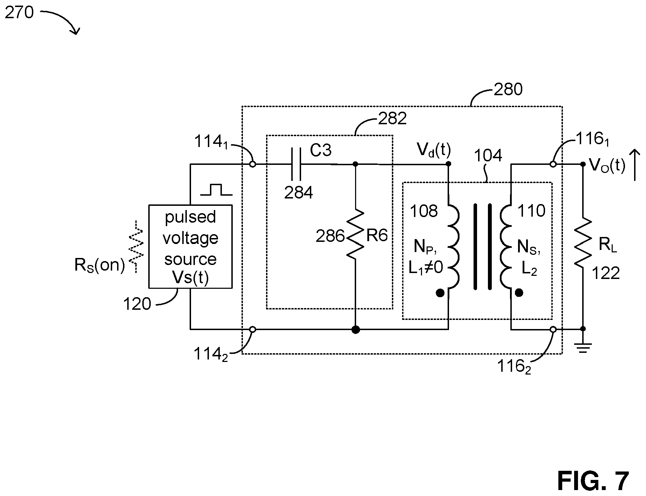

According to a further embodiment of the disclosed technique there is thus provided a differentiator that is coupled with a primary winding of a transformer, in which the differentiator is separate from the transformer (i.e., differentiator and transformer don't have shared components, that is, component-wise they are mutually exclusive). To further detail this embodiment, reference is now made to Figure 7, which is a schematic diagram of a device, generally referenced 270, for derivative voltage and current sensing of a pulsed voltage source, constructed and operative in accordance with a further embodiment of the disclosed technique.

Device 270 is similar to device 100 (Figure 4A) with identical components and their respective reference numbers remaining the same, apart from a differentiator 282 that is separate from transformer 104 (i.e., differentiator 282 and transformer 104 do not have shared components). Specifically, device 280 includes differentiator 282 and transformer 104, where differentiator 282 is of RC-type that includes at least one capacitive element, represented (an interchangeably denoted) by a capacitor 284 (C3), and at least one resistive element, represented (an interchangeably denoted) by a resistor 286 (R6). One terminal of capacitor 284 is connected to resistor 286, while another terminal is connected to pulsed voltage source 120. Transformer 104 includes a primary winding 108 and secondary winding 110. Primary winding 108 is electromagnetically coupled with secondary winding 110 of transformer 104, such that primary winding 108 is configured to electromagnetically induce an induced pulsed voltage on secondary winding 110. Primary winding 108 is connected in parallel to resistor 286. Differentiator 282 forms a closed circuit with pulsed voltage source 120. Device 280 is implemented for derivative voltage and current sensing of pulsed voltage source 120 (or equivalents thereof, such as a switching device). Device 280 including peripherals elements such as voltage source 120 and external load 122 are collectively referenced 270 in Figure 7.

Voltage source 120 is configured to apply a pulsed time-varying (input) signal (not shown) to differentiator 282, which in turn is configured and operative to receive the pulsed time-varying input signal and to differentiate it, thereby generating a differentiated signal (not shown). Transformer 104 is configured and operative to up-convert (i.e., step-up voltage conversion) of the differentiated signal that is received by primary winding 108, thereby generating an up-converted differentiated signal (not shown) that is outputted at output terminals 116₁ and 116₂, represented by V_{O}(t). Device 280 enables at least one of detection and measurement of the up-converted differentiated signal at output terminals 116₁ and 116₂ via measurement of output voltage that is indicative of the pulsed voltage source. Alternatively, device 280 enables at least one of detection and measurement of current through a sensing device 122 (e.g., a resistive load, represented by a resistor R_{L}) that is coupled with output terminals 116₁ and 116₂.

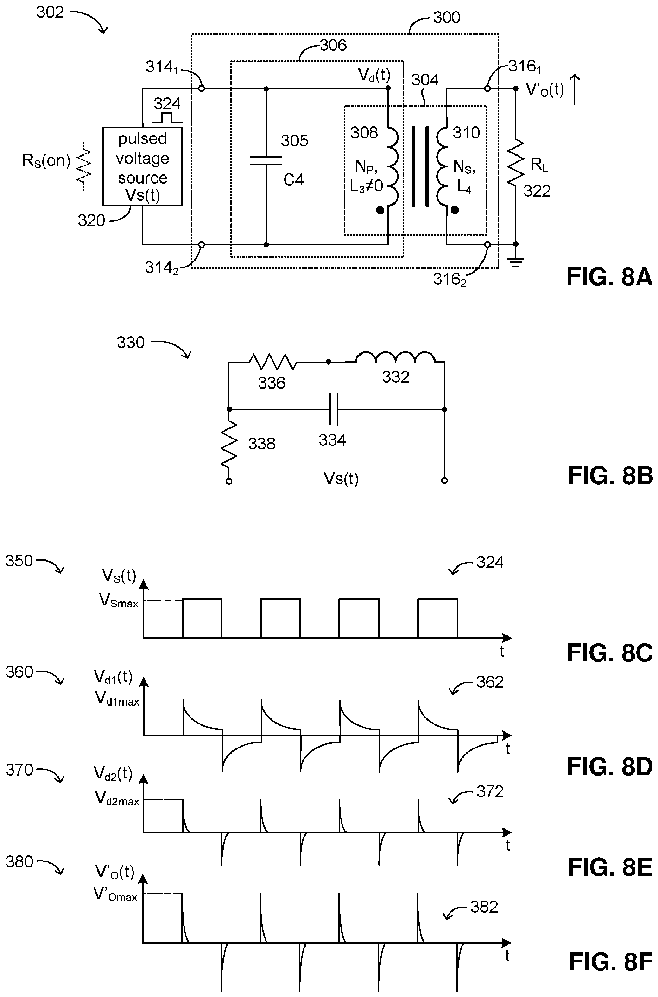

According to a another embodiment of the disclosed technique there is thus provided a resonant circuit having a capacitor that forms an LC circuit with a primary winding of a transformer. The resonant circuit forms a closed circuit with a pulsed voltage source. The primary winding of the transformer induces an induced pulsed voltage on a secondary winding of the transformer, such that the induced pulsed voltage is indicative of the pulsed voltage source. To further detail this embodiment, reference is now made to Figures 8A, 8B, and 8C. Figure 8A is a schematic diagram of a device utilizing a resonant circuit for derivative voltage and current sensing of a pulsed voltage source, generally referenced 300, constructed and operative in accordance with a another embodiment of the disclosed technique. Figure 8B is a schematic illustration of a basic example equivalent circuit, generally referenced 330, of the resonant circuit of the device in Figure 8A. Figure 8C is a schematic illustration, generally referenced 350, of a characteristic plot of an input time-dependent pulsed signal of a pulsed voltage source. All components of device 300 (Figure 8A) are basically the same as corresponding components in device 100 (Figure 4A), except for the exclusion of resistor 112 (from device 300) and the inclusion of a capacitor C4 in device 300 (Figure 8A). Device 300 is implemented for derivative voltage and current sensing of a pulsed voltage source (or equivalents thereof such a switching device).

Specifically, device 300 includes a transformer 304 and a resonant circuit 306. Transformer 304 includes a primary winding 308, and a secondary winding 310, in which the primary and secondary windings are electromagnetically coupled with each other. Similarly to device 100 (Figure 4A), primary winding 308 includes N_{P} winding(s), and has a first inductance, L₃ (that is non-zero). Secondary winding 310 of device 300 includes N_{S} winding(s), and has a second inductance, L₄ (that can be zero). Resonant circuit 306 includes at least one (electrical) capacitive (capacitance) element represented by a capacitor 305 coupled to primary winding 308, thereby forming a parallel LC circuit. Hence, the main inductive component in resonant circuit 306 is common with primary winding 308 of transformer 304. The at least one capacitive element is typically embodied in the form of a capacitor. Alternatively, the at least one capacitive element is embodied as a plurality of capacitors coupled together (not shown) to form an effective capacitor. Device 300 further includes input terminals 314₁ and 314₂ and output terminals 316₁ and 316₂ as shown in Figure 8A. Device 300 is configured and operative to be coupled via input terminals 314₁ and 314₂ with an external, time-varying voltage source 320 that is pulsed ("pulsed voltage source"), denoted by Vs(t) and characterized by having an internal resistance during an 'ON' state (i.e., Rₛ(on)). Resonant circuit 306 and specifically the parallel-coupled pair of capacitor 305 and primary winding 308 is configured to form a closed circuit with pulsed voltage source 320, as shown in Figure 8A. Primary winding 308 is configured and operative to electromagnetically induce an induced pulsed voltage on secondary winding 310, such that the induced pulsed voltage is indicative of pulsed voltage source 320, as will be described in detail herein below. Also, device 300, and specifically secondary inductor 310 are configured and operative to be coupled, via output terminals 316₁ and 316₂ with an external load 322 (R_{L}), i.e., a "sensing load" through which current flows and can be detected and measured. Device 300 including peripherals elements such as voltage source 320 and external load 322 are collectively referenced 302 in Figure 8A. Note that the at least one capacitive element is represented by capacitor 305, which can be embodied a single capacitor, a plurality of capacitors (in series and/or in parallel), or an equivalent device that exhibits electrical capacitance, which is compatible with the principles of the disclosed technique.

Pulsed voltage source 320 is configured to apply a pulsed signal 324 to resonant circuit 306 thus forming a closed circuit with pulsed voltage source 320. Figure 8C shows a characteristic plot 350 of an input time-dependent pulsed signal of pulsed voltage source 320. Pulsed signal 324 is a time-varying signal whose waveform includes rising and falling edges. Without loss of generality, pulsed signal 324 was selected for the purposes of elucidating the disclosed technique to be a square pulse having a duty cycle of 50%. The principles of disclosed technique are likewise applicable to other types of pulsed signals having different duty cycles (e.g., rectangular pulse having a duty cycle of 20%).

Figure 8B shows a basic model of an equivalent circuit 330 of resonant circuit 306 (Figure 8A) of device in 300. Equivalent circuit 330 includes an inductor 332 that models the non-zero inductance of primary winding 308 (Figure 8A), a capacitor 334 that models the capacitance of capacitor 305 (Figure 8A), a resistor 336 that models the electrical resistance of primary winding 308, and resistor 338 that models the series-resistance of resonant circuit 306 (Figure 8A). Resistors 336 and 338 represent the real-world dissipative (electrical resistance) elements of resonant circuit 306.

Given applied time-dependent pulsed signal 324 of pulsed voltage source 320, the consequent time-dependent voltage drop on inductor 308, generally denoted V_{d}(t) is generally dependent upon the values of the components in equivalent circuit 330 shown in Figure 8B. To further explicate this dependence, reference is now further made to Figures 8D, 8E, and 8F. Figure 8D is a schematic illustration of a characteristic plot, generally referenced 360, of a time-dependent voltage drop on the primary winding of the transformer according to a first model configuration of the resonant circuit of the device of Figure 8A. Figure 8E is an illustration, generally referenced 370, of a characteristic plot of a time-dependent voltage drop on the primary winding of the transformer according to a second model configuration of the resonant circuit of the device of Figure 8A. Figure 8F is a characteristic plot, generally referenced 380 of an output voltage as a function of time of the device of Figure 8A, in accordance with the embodiment of the disclosed technique.

Without loss of generality and for the purposes of elucidating the principles of the disclosed technique two example configurations of the resonant circuit will now be described. With reference to Figure 8D, plot 360 illustrates a characteristic waveform 362 of the voltage drop on primary winding as a function of time, denoted V_{d1}(t), in response to applied time-dependent pulsed signal 324 (Figure 8C), according to a first (example) model configuration of resonant circuit 306 of device 300 (Figure 8A), as modeled by equivalent circuit 330 (Figure 8B). According to the first model configuration of resonant circuit 306 the value of resistor 336 has a relatively small resistance value (0.1Ω), so as to produce a slight dissipative effect on resonant circuit 306. The other example values of the components are: capacitor 334 is 10µF; inductor 332 is 0.2µH; and resistor 338 is 0Ω. The frequency of applied (periodic) pulsed signal 324 is selected to match the resonant frequency, *f*₀ of resonant circuit 306, which is given by: ${f}_{0} = 1 / 2 π \sqrt{{L}_{3} {C}_{3}}$ (5).

According to another general alternative preference, L₃ and C₃ are selected such that the period *T*₀ *=* 1/ *f*₀ is greater than a pulse width of the applied (periodic) pulsed signal 324. The maximum voltage drop on primary winding 308, denoted by V_{d1max} generally depends on the maximum voltage of pulsed voltage signal 324, denoted by V_{Smax} as well as other factors such as the rise and fall times of pulsed voltage signal 324.

According to a second example model configuration, resonant circuit 306 exhibits a larger dissipative effect, whereby resistor 336 assumes a value one order of magnitude larger (i.e., 1Ω) compared to the first example model of resonant circuit 306. Figure 8E illustrates a schematic illustration of a characteristic plot, generally referenced 360 of a time-dependent waveform 372 of the voltage drop on the primary winding of the transformer according to a second model configuration of the resonant circuit of the device of Figure 8A. In this second example model configuration, apart from the change of value of resistor 336, all of the values of the other components remain unchanged, including the resonant frequency. The larger dissipative effect of resistor 336 impacts the maximum voltage drop on primary winding 308, denoted by V_{d2max}, which is in general, less than V_{d1max}.

In response to a time-varying current flowing through primary winding 308 (i.e., having non-zero inductance, L₃ ≠ 0) is configured and operative to produce a varying magnetic field that propagates through the electromagnetically-coupled secondary inductor 310, which in turn produces a time-varying output voltage V'_{O}(t) between output terminals 316₁ and 316₂. The induced pulsed output voltage V'_{O}(t) is indicative of input pulsed voltage source Vs(t). The maximum output voltage V'_{Omax} (i.e., *V'_{Oₘₐₓ}* = *max* {*V_{O}*(*t*)}), is given (ideally by): $V {′}_{{O}_{max}} = \frac{{N}_{S}}{{N}_{P}} {V}_{dmax} = {nV}_{{L}_{3 max}}$ (6) where *n* is the turns ratio of transformer 304, and *V_{dmax}* = *V*_{*L*₃*max*} is the maximum voltage on primary winding 308. The maximum output voltage, V'_{Omax}, is thus n times the voltage on inductor 308, which in turn is indicative of the voltage of pulsed voltage source 320. Figure 8F shows a schematic illustration of a characteristic plot, generally referenced 380 of an output voltage waveform 382 as a function of time of the device of Figure 8A, in accordance with the embodiment of the disclosed technique. For measuring the current flowing through secondary winding 310, device 300 is configured and operative for coupling via output terminals 316₁ and 316₂ with a sensing load R_{L}, for example, in the form of a sensing resistor 322. The current flowing through a closed circuit formed by secondary winding 310 and sensing resistor 322 can be detected and measured via current measuring devices (not shown) (e.g., a current detection circuit, an ammeter, and the like). (Note that Fig. 8F is not shown to scale with respect to Figures 8E and 8E.)

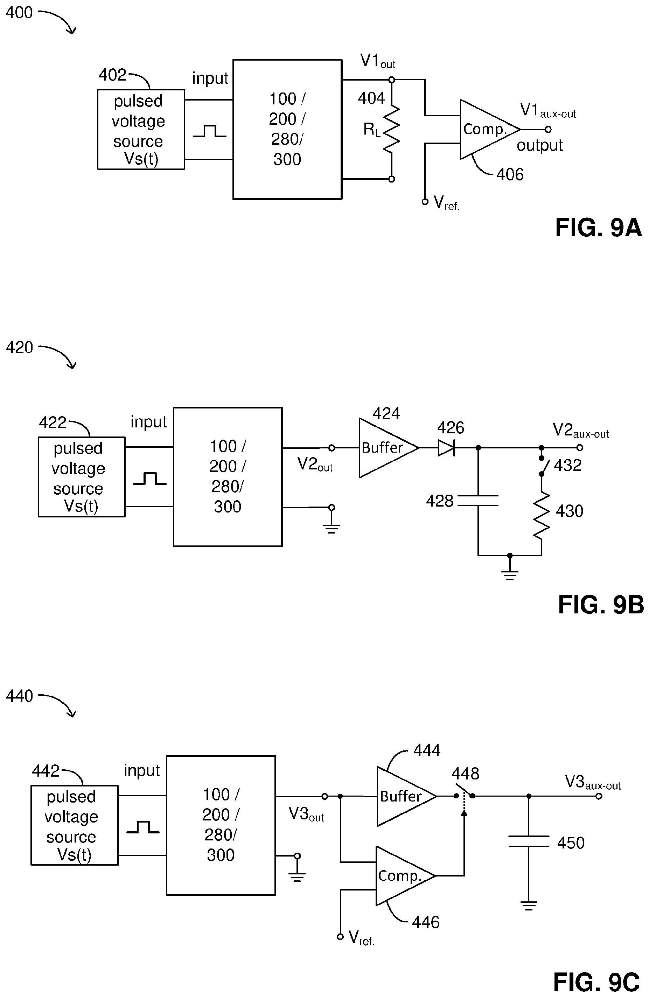

The devices of the disclosed technique, specifically, device 100 (Figure 4A), device 200 (Figure 6A), device 280 (Figure 7), and device 300 (Figure 8A) are each configured and operative to be used with various auxiliary output detection and measurement circuits and devices that are configured and operative to at least sense, condition, or modify an output signal from each of devices 100, 200, 280, and 300 so as to yield data that at least relates or is indicative to the pulsed voltage source. Reference is now made to Figures 9A, 9B, and 9C. Figure 9A is a schematic diagram of an example implementation, generally referenced 400, of an auxiliary output detection and measurement comparator circuit, configured to be used with the devices of the disclosed technique. Figure 9B is a schematic diagram of another example implementation, generally referenced 420, of an auxiliary output peak/envelope detector circuit, configured to be used with the devices of the disclosed technique. Figure 9C is a schematic diagram of a further example implementation, generally referenced 440, of an auxiliary output comparator peak detector, configured to be used with the devices of the disclosed technique.

With reference to Figure 9A, example implementation 400 includes a pulsed voltage source 402 (similar to 120 (Figure 4A); alternatively, similar to MOSFET 152 (Figure 5); alternatively, a shunt resistor) that is input to either one of device 100 (Figure 4A), device 200 (Figure 6A), and device 300 (Figure 8A) (denoted herein by "100 / 200 / 300"), a sensing (load) resistor R_{L} 404, and a comparator 406. Pulsed voltage source 402 provides a source of pulses (or one pulse) to the input of either one of devices 100, 200, 280, and 300, the output of which, V1ₒᵤₜ is indicative of pulsed voltage source 402 in accordance with an afore-described embodiment of the respective device. Sense resistor 404 is coupled with the output terminals of either one of devices 100, 200, 280, and 300, and one terminal of comparator 406 is coupled with of the output terminals (and sense resistor 404), as shown in Figure 9A. Comparator 406 is configured and operative to compare output voltage V1ₒᵤₜ with a reference voltage V_{ref}., and produce an output V1ₐᵤₓ₋ₒᵤₜ that is dependent upon a comparison between V1ₒᵤₜ and V_{ref.}. For example, if V1ₒᵤₜ > V_{ref} then V1ₐᵤₓ₋ₒᵤₜ = V1ₒᵤₜ, and if V1ₒᵤₜ < V_{ref} then V1ₐᵤₓ₋ₒᵤₜ = V_{ref.} (i.e., alternatively, V1ₐᵤₓ₋ₒᵤₜ = 0). Alternatively, comparator 406 is configured and operative to compare between currents (not shown). Implementation 400 can thus indicate if the output of either one of devices 100, 200, 280, and 300 is greater than or less than a reference value (e.g., a threshold, a user selected value, etc.). Comparator 406 can be implemented by an operational amplifier, a dedicated integrated comparator, a comparator circuit involving transistors, an integrated circuit (IC), and the like.

Figure 9B illustrates an example implementation 420 that includes a pulsed voltage source 422 (similar to pulsed voltage source 402 (Figure 9A)) that is input to one of devices 100, 200, 280, and 300, a buffer 424, a diode 426, a capacitor 428, a resistor 430, and a switch 432. Pulsed voltage source 422 provides a source of pulses to the input of either one of devices 100, 200, 280, and 300, the output of which, V2ₒᵤₜ is indicative of pulsed voltage source 402 in accordance with an afore-described embodiment of the respective device. Output V2ₒᵤₜ serves as an input to buffer 424. Buffer 424 is connected to an anode terminal of diode 426. A cathode terminal of diode 426 is connected one terminal of capacitor 428, while another terminal of capacitor 428 is grounded. Switch 432 is configured and operative to switch between utilization and non-utilization of resistor 430. When switch 432 is closed, an RC circuit is formed from capacitor 428 and resistor 430. Buffer 424 is generally configured and operative to isolate its input V2ₒᵤₜ from its output (e.g., by providing isolation between a high input impendence level and a low output impendence level). Buffer 424 outputs an output signal (not shown) that serves as an input to diode 426, which in turn rectifies the output signal, the output of which charges capacitor 428. When switch 432 is open, diode 426 and capacitor 428 are configured and operative as a peak (voltage) detector, such that when capacitor 428 is charged to a peak voltage, the output V2ₐᵤₓ₋ₒᵤₜ is held at that voltage peak. Diode 426 conducts only when forward-biased such that capacitor 428 charges to a new peak (taking into account the diode's forward voltage drop that depends on the diode, e.g., 0.6V). When an output voltage peak of V2ₐᵤₓ₋ₒᵤₜ (at the cathode) is greater than an input voltage (at the anode), diode 426 is reversed-biased and does not conduct current from capacitor 428 toward the input, thus holding or retaining the output at the same output voltage peak (i.e., minus the diode's forward voltage drop). Alternatively, diode 426 is reversed in polarity thereby functioning in conjunction with a non-polarized capacitor 428 as a negative voltage peak detector (not shown).

When switch 432 is closed, diode 426, capacitor 428, and resistor 430 are configured and operative as an envelope detector whose output V2ₐᵤₓ₋ₒᵤₜ decreases according to a characteristic RC time constant that determines the decay time, when the input voltage (at the anode) falls below the output voltage. Conversely, when the input voltage rises above the output voltage (taking into account the diode's forward voltage drop), diode 426 is forward-biased, and V2ₐᵤₓ₋ₒᵤₜ increases, thus outputting an envelope of the input signal.

Figure 9C illustrates an example implementation 440 that includes a pulsed voltage source 442 (similar to pulsed voltage source 422 (Figure 9B)) that is input to one of devices 100, 200, 280, and 300, a buffer 444, a comparator 446, a switch 448, and a capacitor 450. Pulsed voltage source 442 provides a source of pulses to the input of either one of devices 100, 200, 280, and 300, the output of which, V3ₒᵤₜ is indicative of pulsed voltage source 422 in accordance with an afore-described embodiment of the respective device. Output V3ₒᵤₜ serves as an input to buffer 444 and one terminal of comparator 446. The other terminal of comparator 446 is controlled via a reference voltage V_{ref.}. When switch 448 is closed, an output of buffer 444 is connected to one terminal of capacitor 450 which constitutes output V3ₐᵤₓ₋ₒᵤₜ, while the other terminal of capacitor 450 is grounded. Implementation 440 involves a sample and hold (i.e., interchangeably "follow-and-hold") circuit (i.e., having "sample" and "hold" modes). Implementation 440 exhibits a relatively faster voltage envelope following response than implementation 420 (Figure 9B), as there is no dependence on resistor to influence decay times. In the sample mode, switch 448 is closed and buffer 444 either charges capacitor 450, discharges capacitor 450, or keeps the capacitor voltage constant so to equalize or be proportional to V3ₒᵤₜ. In the hold mode, switch 448 is open, and capacitor 450 holds its electric charge (i.e., eventually and typically it may discharge owing to leakage currents). Comparator 446 is configured to compare between voltages V3ₒᵤₜ and V_{ref.}, and further configured and operative to control the switching operation of switch 448 according the result of the comparison (and a selected value of V_{ref.}). Alternatively, other auxiliary devices may be coupled with the output terminals of at least one of devices 100, 200, 280, and 300 (not shown), such as a voltage analyzer, a current analyzer, a voltmeter, an ammeter, a voltage/current sensing device in general, and the like.

Devices 100, 200, 280, 300 of the disclosed technique may be employed to rapidly detect a short-circuit condition or event of a monitored device. Generally, modern wide-band gap semiconductor power transistors have a limited capability to withstand avalanche operational mode in contrast to Silicon (Si) counterparts. Devices 100, 200, 280, and 300 of the disclosed technique can be incorporated into protection circuits having a very short reaction time that enables to save and protect power electronic systems that are based on power transistors in the case of a short-circuit event. Specifically, owing to the fast response between the rise time of an input V_{IN} pulse signal and the corresponding output induced pulse voltage signal V_{OUT}, the output induced pulse voltage may be indicative of a short-circuit condition or event (i.e., characterized by an upsurge (rapid rate of ascent) of current, and a corresponding downfall (rapid rate of descent) in voltage).

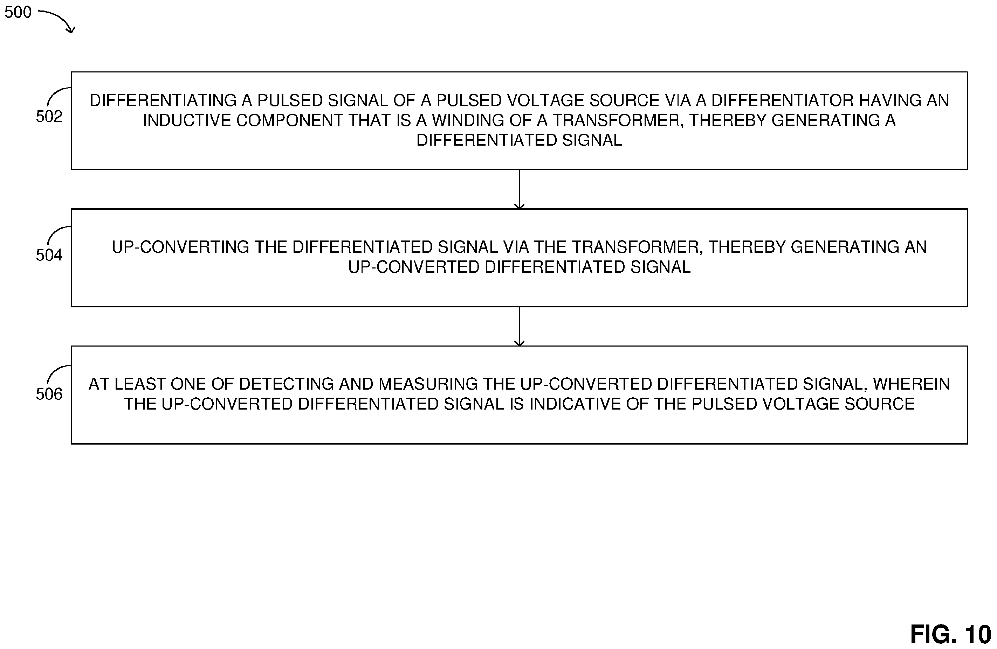

Reference is now further made to Figure 10, which is a schematic block diagram of a method, generally referenced 500, for at least one of detecting and measuring a pulsed voltage source, in accordance with the principles of the disclosed technique. Method 500 initiates with procedure 502. In procedure 502, a pulsed signal of a pulsed voltage source is differentiated via a differentiator having an inductive component that is a winding of a transformer, thereby generating a differentiated signal. With reference to Figures 4A, 4B, and 4C, a pulsed signal Vₛ(t) of pulsed voltage source 120 (Figure 4A) is differentiated via a differentiator 106 having an inductive component that is a winding (primary) 108 of transformer 104 (Figures 4A and 4B), thereby generating a differentiated signal (V_{d}(t)). According to an alternative procedure (not shown in Figure 10) a pulsed signal of pulsed voltage source is differentiated via a differentiator having an RC circuit that is separate (mutually exclusive component-wise) from the transformer. With reference to Figure 7, differentiator 282 differentiates a pulsed signal of pulsed voltage source 120, thereby generating a differentiated signal V_{d}(t).

In procedure 504, the differentiated signal is up-converted via the transformer, thereby generating an up-converted differentiated signal. With reference to Figures 4A, 4B, and 4C, differentiated signal (V_{d}(t)) is up-converted ("stepped-up") via transformer 104 (Figures 4A and 4B), thereby generating an up-converted differentiated signal V_{O}(t) Figures (4A, 4B, and 4C). Specifically, Figure 4C illustrates a characteristic plot of output voltage V_{O}(t) as a function of time, denoted by 144, plotted along with a plot of the time-dependent input pulsed signal 142 of pulsed voltage source 120.

In procedure 506, the up-converted differentiated signal is at least one of detected and measured, wherein the up-converted differentiated signal is indicative of the pulsed voltage source. With reference to Figures 4A, 4B, and 4C up-converted differentiated signal V_{O}(t) can be detected and measured via an external resistive load 122 (R_{L}) (i.e., a "sensing load", "sensing resistor", "resistive load", which are all interchangeable terms) coupled to output terminals 116₁ and 116₂ of device 200 by detecting or measuring a voltage drop on resistive load 122 that is indicative of the pulsed voltage source, as well as detecting or measuring current flowing through resistive load 122 that is indicative of the pulsed voltage source. With further reference to Figures 9A, 9B, and 9C, auxiliary output detection and measurement comparator circuit 400 (Figure 9A) is employed to detect and measure pulsed voltage source 402. Alternatively, auxiliary output peak/envelope detector 420 (Figure 9B) is employed to detect pulsed voltage source 422. Further alternatively, auxiliary output comparator peak detector 440 (Figure 9C) is employed to measure and detect pulsed voltage source 442.

It will be appreciated by persons skilled in the art that the disclosed technique is not limited to what has been particularly shown and described hereinabove. Rather the scope of the disclosed technique is defined only by the claims, which follow.

## Claims

1. A device (100) for at least one of detecting and measuring a pulsed current flowing through a transistor (152), the device comprising:
said transistor exhibiting an ON-resistance value, whereby input terminals (114₁, 114₂) of the device (100) are respectively connected to drain and source terminals of said transistor (152);
a transformer (104) having a primary winding (108) electromagnetically coupled with a secondary winding (110), said primary winding having a first inductance; and
a differentiator (106) that includes at least one resistive element (112) coupled with said primary winding with one end, and coupled with the input terminal (114₁) of the device (100) with the other end, thereby forming a closed circuit with said transistor, said differentiator is configured to electromagnetically induce an induced pulsed voltage on said secondary winding;
wherein said induced pulsed voltage is indicative of said pulsed current, and correlated to said ON-resistance value.

2. The device according to claim 1, wherein said at least one resistive element is a resistor coupled in series with said primary winding.

3. The device according to claim 1, wherein said first inductance is non-zero.

4. The device according to claim 1, wherein said secondary winding has output terminals configured to couple with an external resistive load (122).

5. The device according to claim 1, wherein a maximum value of said induced pulsed voltage is proportional to a turns ratio between said secondary winding and said primary winding.

6. The device according to claim 5, wherein said maximum value is on the order of individual volts.

7. The device according to claim 4, wherein said external resistive load enables measurement of current flowing therethrough.

8. The device according to claim 1, wherein said transistor is selected from a list consisting of:
a general switch;
a mechanical switch;
an electronic switch;
an electromagnetic switch; and
an electro-mechanical switch

9. The device according to claim 1, wherein the device further comprises a direct current, DC, decoupler (204) in between said at least one resistive element and said transistor, said DC decoupler is configured to block at least one time-unvarying DC component of said pulsed current.

10. The device according to claim 9, wherein said DC decoupler is a capacitor coupled in series with said at least one resistive element.

11. The device according to claim 9, wherein said DC decoupler is configured to provide high-voltage, HV, protection to said device.

12. The device according to claim 9, wherein a peak-to-peak voltage of said induced pulsed voltage is over one volt.

13. The device according to claim 1, wherein said secondary winding has output terminals configured to couple with at least one auxiliary device, selected from a list consisting of:
a comparator,
peak/envelope detector;
comparator peak detector;
voltage analyzer;
current analyzer;
voltmeter; and
ammeter.

14. A device (300) for at least one of detecting and measuring a pulsed current flowing through a transistor (152), the device comprising:
said transistor exhibiting an ON-resistance value, whereby input terminals (314₁, 314₂) of the device (300) are respectively connected to drain and source terminals of the transistor (152);
a transformer (304) having a primary winding (308) electromagnetically coupled with a secondary winding (310), said primary winding having a first inductance; and
a resonant circuit (306) that includes at least one capacitive element (305) forming an LC circuit with said primary winding, said resonant circuit coupled to the input terminals (314₁, 314₂) of the device (300) thereby forming a closed circuit with said transistor (152), said primary winding configured to electromagnetically induce an induced pulsed voltage on said secondary winding;
wherein said induced pulsed voltage is indicative of said pulsed current, and correlated to said ON-resistance value.

15. The device according to claim 14, wherein said at least one capacitive element is a capacitor coupled in parallel with said primary winding.

16. The device according to claim 15, wherein said first inductance is non-zero.

17. The device according to claim 15, wherein said secondary winding has output terminals configured to couple with an external resistive load.

18. The device according to claim 14, wherein a maximum value of said induced pulsed voltage is proportional to a turns ratio between said secondary winding and said primary winding.

19. The device according to claim 18, wherein said maximum value is on the order of individual volts.

20. The device according to claim 17, wherein said external resistive load enables measurement of current flowing therethrough.

21. The device according to claim 14, wherein said transistor is selected from a list consisting of:
a general switch;
a mechanical switch;
an electronic switch;
an electromagnetic switch; and
an electro-mechanical switch.

22. The device according to claim 14, wherein a resonant frequency of said resonant circuit is selected to match a frequency of said pulsed current.

23. The device according to claim 14, wherein said secondary winding has output terminals configured to couple with at least one auxiliary device, selected from a list consisting of:
a comparator,
peak/envelope detector;
comparator peak detector;
voltage analyzer;
current analyzer;
voltmeter; and
ammeter.

24. A device (280) for at least one of detecting and measuring a pulsed current flowing through a transistor (152), the device comprising:
said transistor exhibiting an ON-resistance value, whereby input terminals (114₁, 114₂) of the device (280) are respectively connected to drain and source terminals of the transistor (152);
a differentiator (282) that includes at least one resistive element (286) coupled with at least one capacitive element (284), said differentiator (282) coupled to the input terminals (114₁, 114₂) of the device (280) thereby forming a closed circuit with said transistor (152), and
a transformer (104) having a primary winding (108) electromagnetically coupled with a secondary winding (110), said primary winding is connected in parallel to said at least one resistive element, said primary winding is configured to electromagnetically induce an induced pulsed voltage on said secondary winding;
wherein said induced pulsed voltage is indicative of said pulsed current, and correlated to said ON-resistance value.

25. The device according to claim 24, wherein said at least one resistive element is a resistor.

26. The device according to claim 24, wherein said at least one capacitive element is a capacitor coupled in series with said at least one resistive element.

27. The device according to claim 24, wherein said first inductance is non-zero.

28. The device according to claim 24, wherein a maximum value of said induced pulsed voltage is proportional to a turns ratio between said secondary winding and said primary winding.

29. The device according to claim 28, wherein said maximum value is on the order of individual volts.

30. A method (500) for at least one of detecting and measuring a pulsed current flowing through a transistor, said transistor exhibiting an ON-resistance value, the method comprising:
regulating the switching of said pulsed current via said transistor;
differentiating (502) a pulsed signal of said pulsed current via a differentiator having an inductive component that is a winding of a transformer, thereby generating a differentiated signal;
up-converting (504) said differentiated signal via said transformer, thereby generating an up-converted differentiated signal; and
performing (506) at least one of detecting and measuring said up-converted differentiated signal, wherein said up-converted differentiated signal is indicative of said pulsed current, and correlated to said ON-resistance value.

31. The method according to claim 30, wherein said winding is a primary winding of said transformer.

32. The method according to claim 30, wherein said up-converting has an up-conversion factor that is proportional to a turns ratio of said transformer.

33. The method according to claim 32, wherein a maximum value of said induced pulsed voltage is proportional to a said turns ratio.

34. The method according to claim 33, wherein said maximum value is on the order of individual volts.

35. The method according to claim 30, wherein said at least one of detecting and measuring is of a current flowing through a sensing device coupled with a secondary winding of said transformer.

36. The method according to claim 30, further comprising:
blocking at least one time-varying direct current, DC, component of said pulsed current, prior to differentiating the pulsed signal of said pulsed current.

37. The method according to claim 36, wherein said blocking enables to provide high-voltage, HV, protection to said device.

38. The method according to claim 36, wherein a peak-to-peak voltage of an induced pulsed voltage is over one volt.

39. The device according to claim 1, wherein said transistor is a metal-oxide-semiconductor field-effect transistor, MOSFET.

## Patentansprüche

1. Vorrichtung (100) zum Erfassen und/oder Messen eines durch einen Transistor (152) fließenden Pulsstroms, wobei die Vorrichtung umfasst:
den Transistor, der einen EIN-Widerstandswert aufweist, wobei Eingangsanschlüsse (114₁, 114₂) der Vorrichtung (100) mit dem Drain- bzw. dem Source-Anschluss des Transistors (152) verbunden sind;
einen Transformator (104) mit einer Primärwicklung (108), die elektromagnetisch mit einer Sekundärwicklung (110) gekoppelt ist, wobei die Primärwicklung eine erste Induktivität aufweist; sowie
einen Differenzierer (106), der zumindest ein Widerstandselement (112) umfasst, das mit einem Ende an die Primärwicklung und mit dem anderen Ende an den Eingangsanschluss (114₁) der Vorrichtung (100) gekoppelt ist und dadurch mit dem Transistor einen geschlossenen Stromkreis bildet, wobei der Differenzierer dazu ausgebildet ist, elektromagnetisch eine induzierte Pulsspannung an der Sekundärwicklung zu induzieren;
wobei die induzierte Pulsspannung den Pulsstrom anzeigt und mit dem EIN-Widerstandswert korreliert ist.

2. Vorrichtung nach Anspruch 1, wobei das zumindest eine Widerstandselement ein Widerstand ist, der in Reihe mit der Primärwicklung geschaltet ist.

3. Vorrichtung nach Anspruch 1, wobei die erste Induktivität ungleich Null ist.

4. Vorrichtung nach Anspruch 1, wobei die Sekundärwicklung Ausgangsanschlüsse aufweist, die dazu ausgebildet sind, mit einer externen ohmschen Last (122) gekoppelt zu sein.

5. Vorrichtung nach Anspruch 1, wobei ein Maximalwert der induzierten Pulsspannung proportional zu einem Windungsverhältnis zwischen der Sekundärwicklung und der Primärwicklung ist.

6. Vorrichtung nach Anspruch 5, wobei der Maximalwert in der Größenordnung einzelner Volt liegt.

7. Vorrichtung nach Anspruch 4, wobei die externe ohmsche Last die Messung des durch sie fließenden Stroms ermöglicht.

8. Vorrichtung nach Anspruch 1, wobei der Transistor aus einer Liste ausgewählt ist, bestehend aus:
einem allgemeinen Schalter;
einem mechanischen Schalter;
einem elektronischen Schalter;
einem elektromagnetischen Schalter; und
einem elektromechanischen Schalter.

9. Vorrichtung nach Anspruch 1, wobei die Vorrichtung weiter einen Gleichstrom(DC)-Entkoppler (204) zwischen dem zumindest einen Widerstandselement und dem Transistor umfasst, wobei der DC-Entkoppler dazu ausgebildet ist, mindestens eine zeitunabhängige DC-Komponente des gepulsten Stroms zu blockieren.

10. Vorrichtung nach Anspruch 9, wobei der DC-Entkoppler ein Kondensator ist, der in Reihe mit dem zumindest einen Widerstandselement geschaltet ist.

11. Vorrichtung nach Anspruch 9, wobei der DC-Entkoppler dazu ausgebildet ist, einen Hochspannungs(HV)-Schutz für die Vorrichtung bereitzustellen.

12. Vorrichtung nach Anspruch 9, wobei eine Spannung zwischen zwei Spitzen der induzierten Pulsspannung über einem Volt liegt.

13. Vorrichtung nach Anspruch 1, wobei die Sekundärwicklung Ausgangsanschlüsse aufweist, die dazu ausgebildet sind, mit mindestens einer Hilfsvorrichtung gekoppelt zu sein, die ausgewählt ist aus einer Liste bestehend aus:
einem Komparator,
einem Spitzenwert-/Hüllkurvendetektor;
einem Komparator-Spitzenwertdetektor;
einem Spannungsanalysator;
einem Stromanalysator;
einem Voltmeter; und
einem Amperemeter.

14. Vorrichtung (300) zum Erfassen und/oder Messen eines durch einen Transistor (152) fließenden Pulsstroms, wobei die Vorrichtung umfasst:
den Transistor, der einen EIN-Widerstandswert aufweist, wobei Eingangsanschlüsse (314₁, 314₂) der Vorrichtung (300) mit dem Drain- bzw. dem Source-Anschluss des Transistors (152) verbunden sind;
einen Transformator (304) mit einer Primärwicklung (308), die elektromagnetisch mit einer Sekundärwicklung (310) gekoppelt ist, wobei die Primärwicklung eine erste Induktivität aufweist; und
einen Resonanzkreis (306), der zumindest ein kapazitives Element (305) umfasst, das mit der Primärwicklung einen LC-Kreis bildet, wobei der Resonanzkreis mit den Eingangsanschlüssen (314₁, 314₂) der Vorrichtung (300) gekoppelt ist und dadurch mit dem Transistor (152) einen geschlossenen Stromkreis bildet, wobei die Primärwicklung dazu ausgebildet ist, elektromagnetisch an der Sekundärwicklung eine induzierte Pulsspannung zu induzieren;
wobei die induzierte Pulsspannung den Pulsstrom anzeigt und mit dem EIN-Widerstandswert korreliert ist.

15. Vorrichtung nach Anspruch 14, wobei das zumindest eine kapazitive Element ein Kondensator ist, der parallel zur Primärwicklung geschaltet ist.

16. Vorrichtung nach Anspruch 15, wobei die erste Induktivität ungleich Null ist.

17. Vorrichtung nach Anspruch 15, wobei die Sekundärwicklung Ausgangsanschlüsse aufweist, die dazu ausgebildet sind, mit einer externen ohmschen Last gekoppelt zu sein.

18. Vorrichtung nach Anspruch 14, wobei ein Maximalwert der induzierten Pulsspannung proportional zu einem Windungsverhältnis zwischen der Sekundärwicklung und der Primärwicklung ist.

19. Vorrichtung nach Anspruch 18, wobei der Maximalwert in der Größenordnung einzelner Volt liegt.

20. Vorrichtung nach Anspruch 17, wobei die externe ohmsche Last die Messung des durch sie fließenden Stroms ermöglicht.

21. Vorrichtung nach Anspruch 14, wobei der Transistor aus einer Liste ausgewählt ist, bestehend aus:
einem allgemeinen Schalter;
einem mechanischen Schalter;
einem elektronischen Schalter;
einem elektromagnetischen Schalter; und
einem elektromechanischen Schalter.

22. Vorrichtung nach Anspruch 14, wobei eine Resonanzfrequenz des Resonanzkreises so gewählt ist, dass sie mit einer Frequenz des gepulsten Stroms übereinstimmt.

23. Vorrichtung nach Anspruch 14, wobei die Sekundärwicklung Ausgangsanschlüsse aufweist, die dazu ausgebildet sind, mit mindestens einer Hilfsvorrichtung gekoppelt zu sein, die ausgewählt ist aus einer Liste bestehend aus:
einem Komparator,
einem Spitzenwert-/Hüllkurvendetektor;
einem Komparator-Spitzenwertdetektor;
einem Spannungsanalysator;
einem Stromanalysator;
einem Voltmeter; und
einem Amperemeter.

24. Vorrichtung (280) zum Erfassen und/oder Messen eines durch einen Transistor (152) fließenden gepulsten Stroms, wobei die Vorrichtung umfasst:
den Transistor, der einen EIN-Widerstandswert aufweist, wobei Eingangsanschlüsse (114₁, 114₂) der Vorrichtung (280) mit dem Drain- bzw. dem Source-Anschluss des Transistors (152) verbunden sind;
einen Differenzierer (282), der zumindest ein Widerstandselement (286) umfasst, das mit zumindest einem kapazitiven Element (284) gekoppelt ist, wobei der Differenzierer (282) mit den Eingangsanschlüssen (114₁, 114₂) der Vorrichtung (280) gekoppelt ist und dadurch einen geschlossenen Stromkreis mit dem Transistor (152) bildet, und
einen Transformator (104) mit einer Primärwicklung (108), die elektromagnetisch mit einer Sekundärwicklung (110) gekoppelt ist, wobei die Primärwicklung parallel zu dem zumindest einen Widerstandselement geschaltet ist und dazu ausgebildet ist, elektromagnetisch an der Sekundärwicklung eine induzierte Pulsspannung zu induzieren;
wobei die induzierte Pulsspannung den Pulsstrom anzeigt und mit dem EIN-Widerstandswert korreliert ist.

25. Vorrichtung nach Anspruch 24, wobei das zumindest eine Widerstandselement ein Widerstand ist.

26. Vorrichtung nach Anspruch 24, wobei das zumindest eine kapazitive Element ein Kondensator ist, der in Reihe mit dem zumindest einen Widerstandselement geschaltet ist.

27. Vorrichtung nach Anspruch 24, wobei die erste Induktivität ungleich Null ist.

28. Vorrichtung nach Anspruch 24, wobei ein Maximalwert der induzierten Pulsspannung proportional zu einem Windungsverhältnis zwischen der Sekundärwicklung und der Primärwicklung ist.

29. Vorrichtung nach Anspruch 28, wobei der Maximalwert in der Größenordnung einzelner Volt liegt.

30. Verfahren (500) zum Erfassen und/oder Messen eines durch einen Transistor fließenden Pulsstroms, wobei der Transistor einen EIN-Widerstandswert aufweist, und das Verfahren umfasst:
Regeln des Schaltens des Pulsstroms über den Transistor;
Differenzieren (502) eines gepulsten Signals des Pulsstroms über einen Differenziator mit einer induktiven Komponente, bei der es sich um eine Wicklung eines Transformators handelt, wodurch ein differenziertes Signal erzeugt wird;
Hochwandeln (504) des differenzierten Signals über den Transformator, wodurch ein hochgewandeltes differenziertes Signal erzeugt wird; und
Durchführen (506) des Erfassens und/oder Messens des hochgewandelten differenzierten Signals, wobei das hochgewandelte differenzierte Signal den Pulsstrom anzeigt und mit dem EIN-Widerstandswert korreliert ist.

31. Verfahren nach Anspruch 30, wobei die Wicklung eine Primärwicklung des Transformators ist.

32. Verfahren nach Anspruch 30, wobei das Hochwandeln einen Hochwandlungsfaktor aufweist, der proportional zu einem Windungsverhältnis des Transformators ist.

33. Verfahren nach Anspruch 32, wobei ein Maximalwert der induzierten Pulsspannung proportional zu dem Windungsverhältnis ist.

34. Verfahren nach Anspruch 33, wobei der Maximalwert in der Größenordnung einzelner Volt liegt.

35. Verfahren nach Anspruch 30, wobei das Erfassen und/oder Messen eines Stroms erfolgt, der durch eine Erfassungsvorrichtung fließt, die mit einer Sekundärwicklung des Transformators gekoppelt ist.

36. Verfahren nach Anspruch 30, weiter umfassend:
Blockieren zumindest einer zeitabhängigen Gleichstrom(DC)-Komponente des gepulsten Stroms vor dem Differenzieren des gepulsten Signals des Pulsstroms.

37. Verfahren nach Anspruch 36, wobei das Blockieren es ermöglicht, einen Hochspannungs(HV)-Schutz für die Vorrichtung bereitzustellen.

38. Verfahren nach Anspruch 36, wobei eine Spannung zwischen Spitzen einer induzierten Pulsspannung über einem Volt liegt.

39. Vorrichtung nach Anspruch 1, wobei der Transistor ein Metalloxid-Halbleiter-Feldeffekttransistor (MOSFET) ist.

## Revendications

1. Dispositif (100) pour au moins l'un de détecter et de mésurer un courant pulsé circulant à travers un transistor (152), le dispositif comprenant :
ledit transistor présentant une valeur de résistance ON, moyennant quoi des bornes d'entrée (1141, 1142) du dispositif (100) sont respectivement connectées à des bornes de drain et de source dudit transistor (152) ;
un transformateur (104) ayant un enroulement primaire (108) couplé électromagnétiquement à un enroulement secondaire (110), ledit enroulement primaire ayant une première inductance ; et
un différentiateur (106) qui inclut au moins un élément résistif (112) couplé audit enroulement primaire avec une extrémité, et couplé à la borne d'entrée (1141) du dispositif (100) avec l'autre extrémité, formant ainsi un circuit fermé avec ledit transistor, ledit différentiateur est configuré pour induire électromagnétiquement une tension pulsée induite audit enroulement secondaire ;
dans lequel ladite tension pulsée induite est indicative dudit courant pulsé, et corrélée à ladite valeur de résistance ON.

2. Dispositif selon la revendication 1, dans lequel ledit au moins un élément résistif est une résistance couplée en série audit enroulement primaire.

3. Dispositif selon la revendication 1, dans lequel ladite première inductance est non nulle.

4. Dispositif selon la revendication 1, dans lequel ledit enroulement secondaire a des bornes de sortie configurées pour se coupler à une charge résistive externe (122).

5. Dispositif selon la revendication 1, dans lequel une valeur maximale de ladite tension pulsée induite est proportionnelle à un rapport de tours entre ledit enroulement secondaire et ledit enroulement primaire.

6. Dispositif selon la revendication 5, dans lequel ladite valeur maximale est de l'ordre des volts individuels.

7. Dispositif selon la revendication 4, dans lequel ladite charge résistive externe permet la mésure du courant circulant à travers celle-ci.

8. Dispositif selon la revendication 1, dans lequel ledit transistor est choisi parmi une liste constituée de :
un commutateur général ;
un commutateur mécanique ;
un commutateur électronique ;
un commutateur électromagnétique ; et
un commutateur électromécanique.

9. Dispositif selon la revendication 1, dans lequel le dispositif comprend en outre un découpleur de courant continu, CC, (204) entre ledit au moins un élément résistif et ledit transistor, ledit découpleur CC est configuré pour bloquer au moins une composante CC invariable dans le temps dudit courant pulsé.

10. Dispositif selon la revendication 9, dans lequel ledit découpleur CC est un condensateur couplé en série audit au moins un élément résistif.

11. Dispositif selon la revendication 9, dans lequel ledit découpleur CC est configuré pour fournir une protection haute tension, HV, audit dispositif.

12. Dispositif selon la revendication 9, dans lequel une tension crête à crête de ladite tension pulsée induite est supérieure à un volt.

13. Dispositif selon la revendication 1, dans lequel ledit enroulement secondaire a des bornes de sortie configurées pour se coupler à au moins un dispositif auxiliaire, choisi parmi une liste constituée de :
un comparateur,
un détecteur de crête/enveloppe ;
un détecteur de crête de comparateur ;
un analyseur de tension ;
un analyseur de courant ;
un voltmètre ; et
un ampèremètre.

14. Dispositif (300) pour au moins l'un de détecter et de mésurer un courant pulsé circulant à travers un transistor (152), le dispositif comprenant :
ledit transistor présentant une valeur de résistance ON, dans lequel des bornes d'entrée (3141, 3142) du dispositif (300) sont respectivement connectées à des bornes de drain et de source du transistor (152) ;
un transformateur (304) ayant un enroulement primaire (308) couplé électromagnétiquement à un enroulement secondaire (310), ledit enroulement primaire ayant une première inductance ; et
un circuit résonnant (306) qui inclut au moins un élément capacitif (305) formant un circuit LC avec ledit enroulement primaire, ledit circuit résonnant couplé aux bornes d'entrée (3141, 3142) du dispositif (300) formant ainsi un circuit fermé avec ledit transistor (152), ledit enroulement primaire étant configuré pour induire électromagnétiquement une tension pulsée induite audit enroulement secondaire ;
dans lequel ladite tension pulsée induite est indicative dudit courant pulsé, et corrélée à ladite valeur de résistance ON.

15. Dispositif selon la revendication 14, dans lequel ledit au moins un élément capacitif est un condensateur couplé en parallèle audit enroulement primaire.

16. Dispositif selon la revendication 15, dans lequel ladite première inductance est non nulle.

17. Dispositif selon la revendication 15, dans lequel ledit enroulement secondaire a des bornes de sortie configurées pour se coupler à une charge résistive externe.

18. Dispositif selon la revendication 14, dans lequel une valeur maximale de ladite tension pulsée induite est proportionnelle à un rapport de tours entre ledit enroulement secondaire et ledit enroulement primaire.

19. Dispositif selon la revendication 18, dans lequel ladite valeur maximale est de l'ordre des volts individuels.

20. Dispositif selon la revendication 17, dans lequel ladite charge résistive externe permet la mésure du courant circulant à travers celle-ci.

21. Dispositif selon la revendication 14, dans lequel ledit transistor est choisi parmi une liste constituée de :
un commutateur général ;
un commutateur mécanique ;
un commutateur électronique ;
un commutateur électromagnétique ; et
un commutateur électromécanique.

22. Dispositif selon la revendication 14, dans lequel une fréquence de résonance dudit circuit résonnant est choisie pour correspondre à une fréquence dudit courant pulsé.

23. Dispositif selon la revendication 14, dans lequel ledit enroulement secondaire a des bornes de sortie configurées pour se coupler à au moins un dispositif auxiliaire, choisi parmi une liste constituée de :
un comparateur,
un détecteur de crête/enveloppe ;
un détecteur de crête de comparateur ;
un analyseur de tension ;
un analyseur de courant ;
un voltmètre ; et
un ampèremètre.

24. Dispositif (280) pour au moins l'un de détecter et de mésurer un courant pulsé circulant à travers un transistor (152), le dispositif comprenant :
ledit transistor présentant une valeur de résistance ON, dans lequel des bornes d'entrée (1141, 1142) du dispositif (280) sont respectivement connectées à des bornes de drain et de source du transistor (152) ;
un différentiateur (282) qui inclut au moins un élément résistif (286) couplé à au moins un élément capacitif (284), ledit différentiateur (282) couplé aux bornes d'entrée (1141, 1142) du dispositif (280) formant ainsi un circuit fermé avec ledit transistor (152), et
un transformateur (104) ayant un enroulement primaire (108) couplé électromagnétiquement à un enroulement secondaire (110), ledit enroulement primaire est connecté en parallèle audit au moins un élément résistif, ledit enroulement primaire est configuré pour induire électromagnétiquement une tension pulsée induite audit enroulement secondaire ;
dans lequel ladite tension pulsée induite est indicative dudit courant pulsé, et corrélée à ladite valeur de résistance ON.

25. Dispositif selon la revendication 24, dans lequel ledit au moins un élément résistif est une résistance.

26. Dispositif selon la revendication 24, dans lequel ledit au moins un élément capacitif est un condensateur couplé en série audit au moins un élément résistif.

27. Dispositif selon la revendication 24, dans lequel ladite première inductance est non nulle.

28. Dispositif selon la revendication 24, dans lequel une valeur maximale de ladite tension pulsée induite est proportionnelle à un rapport de tours entre ledit enroulement secondaire et ledit enroulement primaire.

29. Dispositif selon la revendication 28, dans lequel ladite valeur maximale est de l'ordre des volts individuels.

30. Procédé (500) pour au moins l'un de détecter et de mésurer un courant pulsé circulant à travers un transistor, ledit transistor présentant une valeur de résistance ON, le procédé comprenant :
réguler la commutation dudit courant pulsé par l'intermédiaire dudit transistor ;
différencier (502) un signal pulsé dudit courant pulsé par l'intermédiaire d'un différentiateur ayant une composante inductive qui est un enroulement d'un transformateur, générant ainsi un signal différencié ;
convertir à la hausse (504) ledit signal différencié par l'intermédiaire dudit transformateur, générant ainsi un signal différencié converti à la hausse ;
et
effectuer (506) au moins l'un de détecter et de mésurer ledit signal différencié converti à la hausse, dans lequel ledit signal différencié converti à la hausse est indicatif dudit courant pulsé, et corrélé à ladite valeur de résistance ON.

31. Procédé selon la revendication 30, dans lequel ledit enroulement est un enroulement primaire dudit transformateur.

32. Procédé selon la revendication 30, dans lequel ladite conversion à la hausse a un facteur de conversion à la hausse qui est proportionnel à un rapport de tours dudit transformateur.

33. Procédé selon la revendication 32, dans lequel une valeur maximale de ladite tension pulsée induite est proportionnelle au rapport de tours.

34. Procédé selon la revendication 33, dans lequel ladite valeur maximale est de l'ordre des volts individuels.

35. Procédé selon la revendication 30, dans lequel ledit au moins un de détecter et de mésurer est d'un courant circulant à travers un dispositif de détection couplé à un enroulement secondaire dudit transformateur.

36. Procédé selon la revendication 30, comprenant en outre :
bloquer au moins une composante de courant continu, CC, variable dans le temps dudit courant pulsé, avant de différencier le signal pulsé dudit courant pulsé.

37. Procédé selon la revendication 36, dans lequel ledit blocage permet de fournir une protection haute tension, HV, audit dispositif.

38. Procédé selon la revendication 36, dans lequel une tension crête à crête d'une tension pulsée induite est supérieure à un volt.

39. Dispositif selon la revendication 1, dans lequel ledit transistor est un transistor à effet de champ métal-oxyde-semi-conducteur, MOSFET.
